# EUROPEAN PATENT SPECIFICATION

(11) **EP 4 339 227 B1**
(45) Date of publication and mention of the grant of the patent: **29.10.2025**
(21) Application number: 21941999.1
(22) Date of filing: 16.11.2021
(51) Int. Cl.: C08G 77/20, C08L 83/07, H10H 20/854

(54) **THERMOSETTING RESIN COMPOSITION, ORGANOSILICON COMPOUND, MOLDED BODY, AND OPTICAL SEMICONDUCTOR DEVICE**
WÄRMEHÄRTENDE HARZZUSAMMENSETZUNG, ORGANOSILICIUMVERBINDUNG, FORMKÖRPER UND OPTISCHES HALBLEITERBAUELEMENT
COMPOSITION DE RÉSINE THERMODURCISSABLE, COMPOSÉ ORGANOSILICIUM, CORPS MOULÉ ET DISPOSITIF À SEMICONDUCTEUR OPTIQUE

(30) Priority: 14.05.2021 JP 2021082119
(43) Date of publication of application: 20.03.2024
(73) Proprietor: JNC Corporation, Chiyoda-ku Tokyo 100-8105 (JP)
(72) Inventor: KOSUGI, Misa, Ichihara-shi, Chiba 290-8551 (JP); TAKAHASHI, Naoya, Ichihara-shi, Chiba 290-8551 (JP); IKENO, Hironori, Ichihara-shi, Chiba 290-8551 (JP); TAKEE, Ayako, Tokyo 100-8105 (JP)
(74) Representative: Becker, Eberhard
(86) International application number: PCT/JP2021/042031
(87) International publication number: WO 2022/239271

(56) References cited:
- WO-A1-2020/116198
- WO-A1-2020/116198
- JP-A- 2012 031 354
- JP-A- 2015 172 146
- JP-A- 2017 078 103
- JP-A- 2017 119 848
- MITUŁA K., DUSZCZAK J., BRZĄKALSKI D., DUDZIEC B., KUBICKI M., MARCINIEC B.: "Tetra-functional double-decker silsesquioxanes as anchors for reactive functional groups and potential synthons for hybrid materials", CHEMICAL COMMUNICATIONS, ROYAL SOCIETY OF CHEMISTRY, UK, vol. 53, no. 75, 1 January 2017 (2017-01-01), UK , pages 10370 - 10373, XP093004780, ISSN: 1359-7345, DOI: 10.1039/C7CC03958A

## Description

### [Technical Field]

The present invention relates to a thermosetting resin composition, an organosilicon compound, a molded body, and an optical semiconductor device.

### [Background Art]

Optical semiconductor devices including optical semiconductor elements such as light emitting diodes (LEDs) have been put to practical use in various lighting devices, electronic bulletin boards, traffic lights, backlights of liquid crystal display devices, LED displays, and the like. In these optical semiconductor devices, the optical semiconductor elements are generally encapsulated with a transparent encapsulant. In recent years, the heat density per unit volume has tended to increase in the optical semiconductor industry due to demands for higher output and smaller and thinner packages. For this reason, encapsulants for optical semiconductor elements are particularly required to have heat resistance in addition to light transmittance, light refraction properties, and the like. In addition, for internal liquid-type encapsulants for optical semiconductor elements, it is also required to control the viscosity to be within an appropriate range according to a packaging process from demands for operability or productivity in the process.

Silicone resins are widely used as one of encapsulants for optical semiconductor elements. In Patent Literature 1, a crosslinkable silicon compound having a double-decker silsesquioxane structure and a crosslinkable functional group is reported to be used for an encapsulant for optical semiconductor elements with excellent heat resistance. However, when thermosetting resin compositions are prepared to have a relatively low viscosity of 2,000 mPa·s or less, there is a problem that the heat yellowing resistance and thermal cracking resistance are significantly reduced. In Patent Document 2, a method for synthesizing a liquid double-decker silsesquioxane derivative that does not rely on hydrosilylation is reported, but as a thermosetting resin composition, only short-duration heat yellowing resistance is investigated, and the study is insufficient. In Patent Document 3, although the heat resistance is improved, there is a problem that the viscosity of the composition becomes high because the viscosity of the constituent components is high.

### [Citation List]

### [Patent Literature]

[Patent Literature 1]
   PCT International Publication No. WO2011/145638
[Patent Literature 2]
   Japanese Patent Laid-Open No. 2012-31354
[Patent Literature 3]
   Japanese Patent Laid-Open No. 2020-90593

### [Summary of Invention]

### [Technical Problem]

In the internal liquid-type encapsulants for optical semiconductor elements, compatibility between process compatibility represented by viscosity in the state of a resin composition and encapsulating performance represented by heat resistance in the state of a resin-cured product is required. In a case where the thermosetting resin composition of Patent Literature 2 is used to adjust the viscosity to a low level, the proportion of low-molecular-weight components that cause a decrease in heat resistance increases, and there are limitations in lowering viscosity while maintaining heat-resistant transparency, crack resistance, and heat yellowing resistance. In addition, there is a problem that the hardness of an obtained molded body decreases with an increase in the low-molecular-weight components.

The present invention has been made based on the above-described circumstances, and an objective thereof is to provide: a thermosetting resin composition from which a molded body exhibiting little change in optical characteristics when exposed to high temperatures can be obtained, and which can be applied to various packaging processes; an organosilicon compound from which the composition can be achieved; and a molded body and an optical semiconductor device which are obtained using such a thermosetting resin composition.

### [Solution to Problem]

An invention made to solve the above-described problems is a thermosetting resin composition including a component (A), a component (B), and a component (C) below.
Component (A): Organosilicon compound (A1) represented by Formula (1-1) or organosilicon compound (A2) represented by Formula (1-2) (hereinafter, in some cases, organosilicon compound (A1) represented by Formula (1-1) and organosilicon compound (A2) represented by Formula (1-2) are collectively referred to as organosilicon compounds (A)),
Component (B): Organosilicon compound that has plurality of crosslinkable groups in its molecule and is other than organosilicon compounds (A), and
Component (C): Hydrosilylation catalyst
The organosilicon compound (B) contains a compound that is crosslinkable with the organosilicon compounds (A).

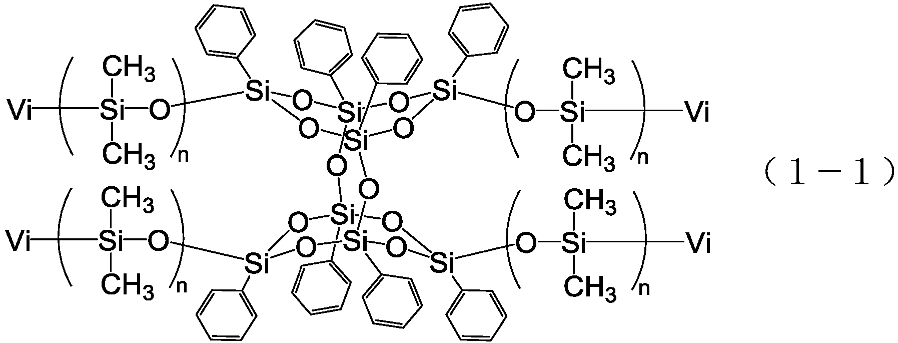

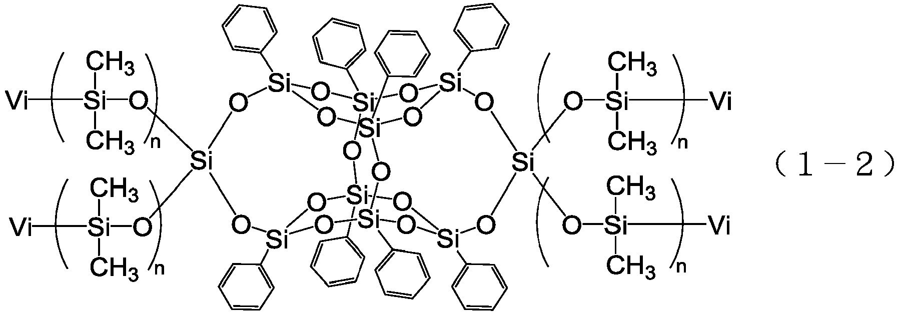

In Formula (1-1) and Formula (1-2), each n is independently an average value whereby 1≤n≤10 is satisfied, and preferably an average value whereby 3≤n≤7 is satisfied. In addition, Vi represents vinyl.

The organosilicon compound (B) preferably contains the compound represented by Formula (2).

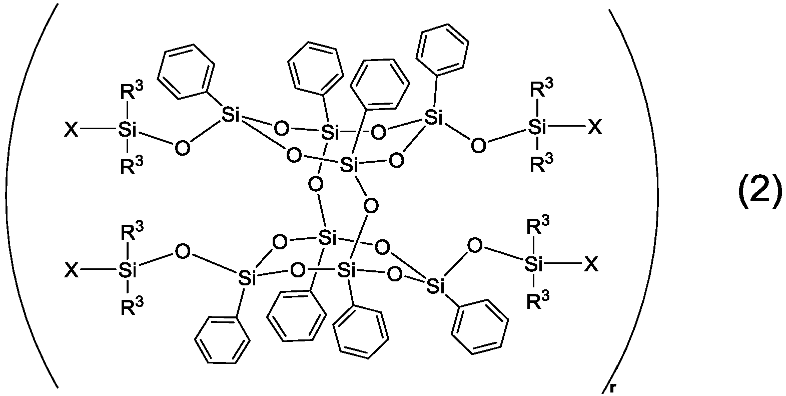

In Formula (2), each R³ is independently cyclohexyl, cyclopentyl, or alkyl having 1 to 4 carbon atoms. Each X is independently a group represented by Formula (X1), Formula (X2), or Formula (X3).

When an average number of groups represented by Formula (X1), an average number of groups represented by Formula (X2), and an average number of groups represented by Formula (X3) per molecule of the compound represented by Formula (2) are respectively x₁, x₂, and x₃, x₁+2x₂+x₃=4r, 0<x₁<4r, 0≤x₂<2r, and 0<x₃<4r are satisfied. r is an average value satisfying being 1 to 100.

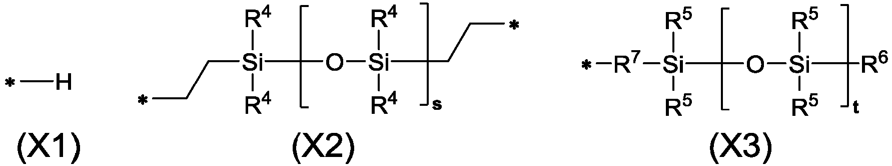

In Formula (X1), Formula (X2), and Formula (X3), * represents a bonding site.

In Formula (X2), each R⁴ is independently phenyl, cyclohexyl, cyclopentyl, or alkyl having 1 to 4 carbon atoms. s is an average value satisfying 2 to 20.

In Formula (X3), each R⁵ is independently phenyl, cyclohexyl, cyclopentyl, or alkyl having 1 to 4 carbon atoms. R⁶ is alkenyl having 2 to 5 carbon atoms. R⁷ is alkanediyl having the same number of carbon atoms as R⁶. t is an average value satisfying 2 to 20.

It is preferable that the organosilicon compound (B) contain the compound represented by Formula (3).

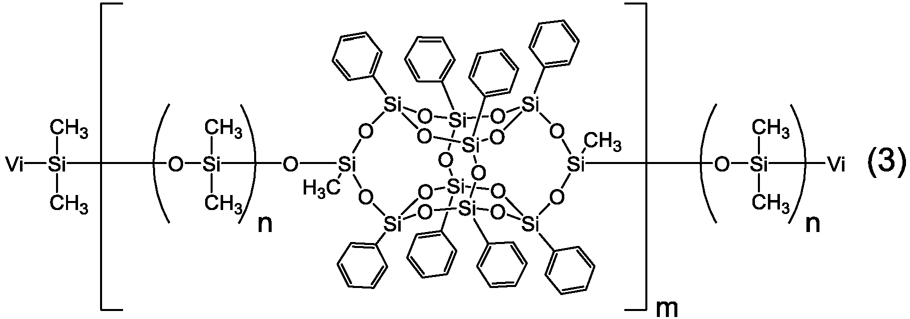

In Formula (3), m is an average value satisfying 1 to 5, n is an average value satisfying 2 to 50, and Vi represents vinyl.

It is preferable that the organosilicon compound (B) contain the compound represented by Formula (4).

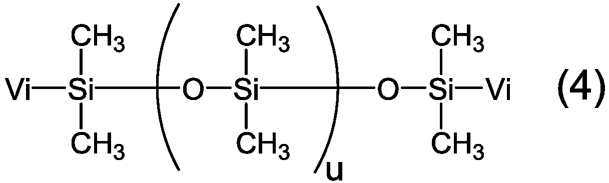

In Formula (4), u is an average value whereby 0≤u≤50 is satisfied, and Vi represents vinyl.

In the thermosetting resin composition, it is preferable that a content of the organosilicon compounds (A) be 5 mass% to 50 mass%.

In the thermosetting resin composition, it is preferable that a weight ratio of a content of the organosilicon compounds (A) and a content of the organosilicon compound (B) be 0.1 to 2.

The thermosetting resin composition further includes an adhesion-imparting agent (D), and it is preferable that the adhesion-imparting agent (D) contain the compound represented by Formula (5).

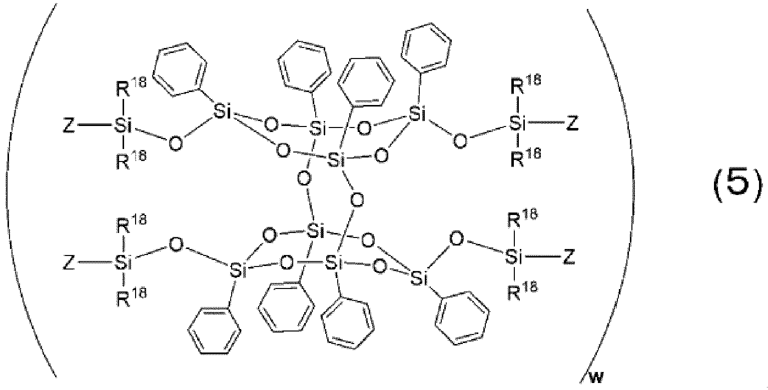

In Formula (5), each R¹⁸ is independently cyclohexyl, cyclopentyl, or alkyl having 1 to 4 carbon atoms. Each Z is independently a group represented by Formula (Z1), Formula (Z2), Formula (Z31), Formula (Z32), Formula (Z33), or Formula (Z41).

When an average number of groups represented by Formula (Z1), an average number of groups represented by Formula (Z2), an average number of groups represented by Formula (Z31), Formula (Z32), or Formula (Z33), and an average number of groups represented by Formula (Z41) per molecule of the compound represented by Formula (5) are respectively z₁, z₂, z₃, and z₄, z₁+2z₂+z₃+z₄=4w, 0.5w≤z₁≤3w, 0.5w≤2z₂≤2w, 0.1w≤z₃≤2w, and 0≤z₄≤w are satisfied. w is an average value satisfying 1 to 100.

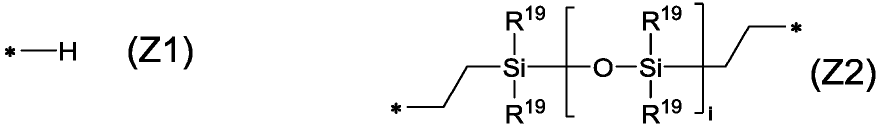

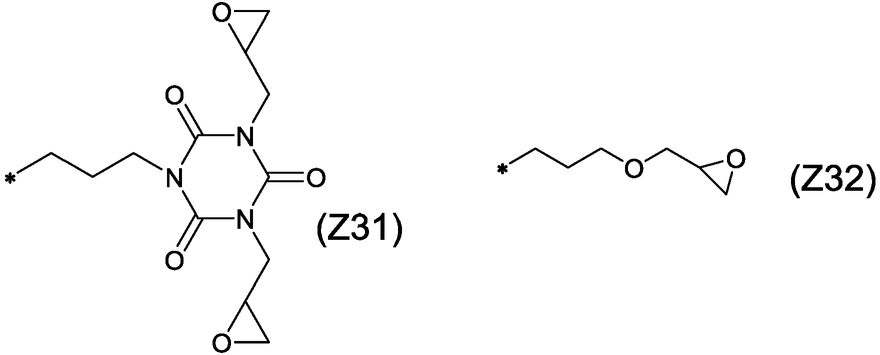

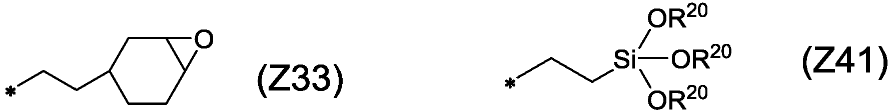

In Formula (Z1), Formula (Z2), Formula (Z31), formula (Z32), Formula (Z33), and Formula (Z41), * represents a bonding site.

In Formula (Z2), each R¹⁹ is independently phenyl, cyclohexyl, cyclopentyl, or alkyl having 1 to 4 carbon atoms. i is an average value satisfying 1 to 20.

In Formula (Z41), each R²⁰ is independently methyl, ethyl, butyl, or isopropyl.

In the thermosetting resin composition, it is preferable that a content of the adhesion-imparting agent (D) be 0.1 mass% to 5 mass%, and it is more preferable that the content thereof be 0.5 mass% to 3 mass%.

It is preferable that the thermosetting resin composition further include: a phosphor (E) or a white pigment (F).

Still another invention made to solve the above-described problems is a molded body obtained by curing the thermosetting resin composition.

Still another invention made to solve the above-described problems is an optical semiconductor device including: an optical semiconductor element; and the molded body that seals the above-described optical semiconductor element.

Still another invention made to solve the above-described problems is an organosilicon compound represented by Formula (1-2).

### [Advantageous Effects of Invention]

According to the present invention, it is possible to provide: a thermosetting resin composition from which a molded body exhibiting little change in optical characteristics when exposed to high temperatures can be obtained, and which can be applied to various packaging processes; an organosilicon compound from which the composition can be achieved; and a molded body and an optical semiconductor device which are obtained using such a thermosetting resin composition.

### [Description of Embodiments]

Hereinafter, a thermosetting resin composition, an organosilicon compound, a molded body, and a optical semiconductor device according to one embodiment of the present invention will be described in detail.

### <Organosilicon compound (A1)>

An organosilicon compound (A1) according to one embodiment of the present invention is represented by Formula (1-1) and consists of a double-decker silsesquioxane structural unit and four dimethylsiloxane units extending therefrom, vinyl being present at a terminal of each dimethylsiloxane unit.

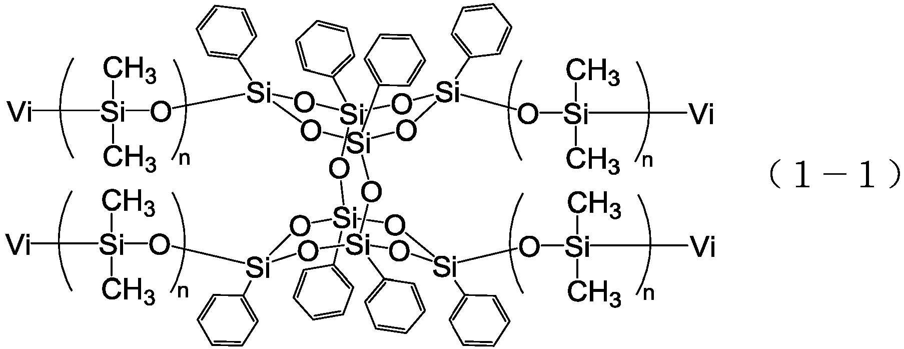

In Formula (1-1), each n is independently an average value whereby 1<n≤10 is satisfied, and preferably 3≤n≤7. Vi represents vinyl.

The lower limit of the viscosity of the organosilicon compound (A1) at 25°C is preferably 10 mPa·s, and in some cases, more preferably 100 mPa·s. On the other hand, the upper limit of the viscosity thereof is preferably 100,000 mPa·s, and in some cases, more preferably 10,000 mPa·s. In a case where the organosilicon compound (A1) has such a viscosity, it has moderate fluidity and is more useful as an encapsulant for semiconductors and the like. The viscosity of the organosilicon compound (A1) can be adjusted by the lengths and the like of the dimethylsiloxane units.

Since the organosilicon compound (A1) has dimethylsiloxane units with a length within a predetermined range, it is possible to obtain a molded body exhibiting little change in optical characteristics when exposed to high temperatures. In addition, in this case, the obtained molded body has a sufficiently high light transmittance and light refractive index.

### <Organosilicon compound (A2)>

An organosilicon compound (A2) according to one embodiment of the present invention is represented by Formula (1-2) and consists of a double-decker silsesquioxane structure unit and four dimethylsiloxane units extending therefrom, vinyl being present at a terminal of each dimethylsiloxane unit.

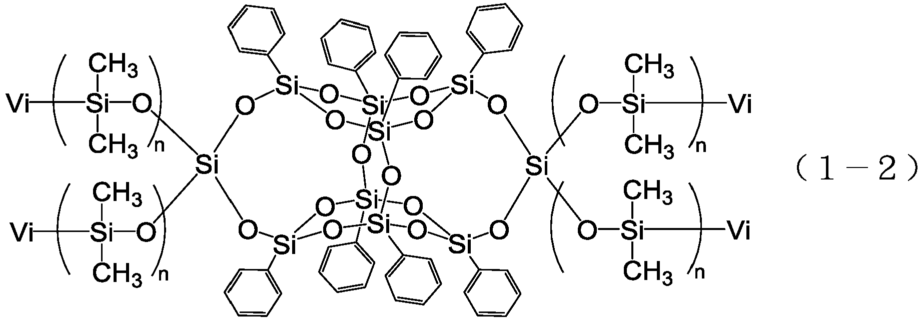

In Formula (1-2), each n is independently an average value whereby 1<n≤10 is satisfied, and preferably 3≤n≤7. Vi represents vinyl.

The lower limit of the viscosity of the organosilicon compound (A2) at 25°C is preferably 10 mPa·s, and in some cases, more preferably 100 mPa·s. On the other hand, the upper limit of the viscosity thereof is preferably 100,000 mPa·s, and in some cases, more preferably 10,000 mPa·s. In a case where the organosilicon compound (A2) has such a viscosity, it has moderate fluidity and is more useful as an encapsulant for semiconductors and the like. The viscosity of the organosilicon compound (A2) can be adjusted by the lengths and the like of the dimethylsiloxane units.

Since the organosilicon compound (A2) has dimethylsiloxane units with a length within a predetermined range, it is possible to obtain a molded body exhibiting little change in optical characteristics when exposed to high temperatures. In addition, the obtained molded body has a sufficiently high light transmittance and light refractive index.

### <Thermosetting resin composition>

The thermosetting resin composition according to one embodiment of the present invention includes: an organosilicon compound (A) which is an organosilicon compound (A1) or an organosilicon compound (A2) (hereinafter also referred to as an "organosilicon compound (A)" or a "component (A)"); an organosilicon compound (B) that has a plurality of crosslinkable groups and is other than the organosilicon compound (A) (hereinafter also referred to as an "organosilicon compound (B)" or a "component (B)"); and a hydrosilylation catalyst (C). The organosilicon compound (B) contains at least a compound that is crosslinkable with the organosilicon compound (A). Since the thermosetting resin composition contains the organosilicon compound (A), the viscosity is low and a molded body obtained through curing has excellent crack resistance in a high-temperature environment. In addition, the obtained molded body has a sufficiently high light transmittance and light refractive index. The total content of the organosilicon compound in the thermosetting resin composition is preferably 90 mass%, more preferably 95 mass%, and still more preferably 99 mass%, and may be approximately 100 mass%.

The thermosetting resin composition may further contain other components. Hereinafter, each component constituting the thermosetting resin composition will be described.

### <Component (A): Organosilicon compound (A)>

The organosilicon compound (A) is an organosilicon compound (A1) or an organosilicon compound (A2). The organosilicon compound (A) may be one compound or a mixture of two or more.

The lower limit of the content of the organosilicon compound (A) in all organosilicon compound in the thermosetting resin composition is preferably 1 mass% and more preferably 5 mass%, and in some cases, still more preferably 10 mass%. On the other hand, the upper limit of the content thereof is preferably 50 mass% and more preferably 40 mass%, and in some cases, still more preferably 30 mass%. By setting the content of the organosilicon compound (A) to be within the above-described ranges, optimization or the like of the mixing ratio with other components lowers the viscosity of the thermosetting resin composition and further improves yellowing resistance of a molded body obtained through curing when exposed to high temperatures.

### <Component (B): Organosilicon compound (B)>

An organosilicon compound (B) may be a single organosilicon compound or may include a plurality of organosilicon compounds, but the organosilicon compound (A) is excluded. In addition, the organosilicon compound (B) has a plurality of crosslinkable groups in its molecule. Examples of crosslinkable groups include alkenyl groups such as vinyl, alkynyl groups such as ethynyl, and hydrosilyl, and vinyl and hydrosilyl are preferable. The organosilicon compound (B) may be one compound or a mixture of two or more. The organosilicon compound (B) contains at least one that is crosslinkable with the organosilicon compound (A). In a case of a form in which vinyl is present at both terminals of the organosilicon compound (A), a compound containing hydrosilyl as a crosslinkable group can be cross-linked with the organosilicon compound (A) through a hydrosilylation reaction. In a case of a form in which hydrosilyl is present at both terminals of the organosilicon compound (A), a compound containing vinyl as a crosslinkable group can be cross-linked with the organosilicon compound (A) through a hydrosilylation reaction. In the organosilicon compound (B), examples of compounds having hydrosilyl include an organosilicon compound (B 1) to be described below. In the organosilicon compound (B), examples of organosilicon compounds having vinyl include organosilicon compounds (B1), (B2), and (B3) to be described below.

In the thermosetting resin composition, the organosilicon compounds (A) and at least one of the organosilicon compounds (B) undergo a cross-linking reaction in the presence of a hydrosilylation catalyst (C) to obtain a cured product. A cross-linking reaction may occur between the organosilicon compounds (B). Hereinafter, organosilicon compounds (B1) to (B3) suitable as the organosilicon compounds (B) will be described. That is, the organosilicon compounds (B) preferably include one kind or two or more kinds of the organosilicon compounds (B1) to (B3).

### <Organosilicon compound (B1)>

The organosilicon compound (B 1) is an organosilicon compound having hydrosilyl, vinyl, and silsesquioxane structures. Since the organosilicon compound (B 1) has a silsesquioxane structure, the heat resistance of an obtained molded body can be further improved. Examples of the organosilicon compounds (B1) include the compound represented by Formula (2).

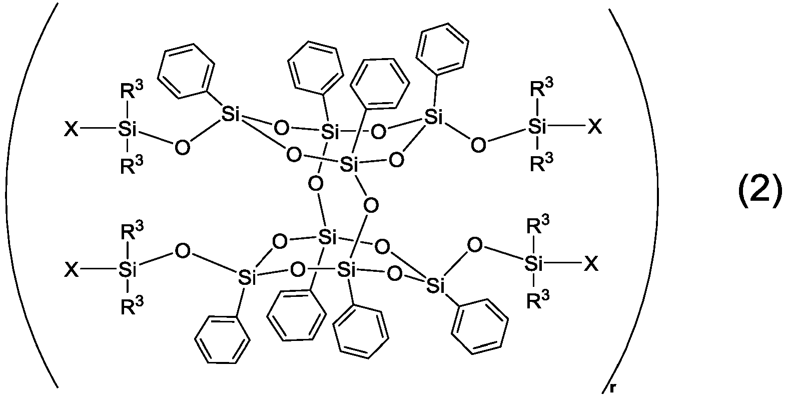

In Formula (2), each R³ is independently cyclohexyl, cyclopentyl, or alkyl having 1 to 4 carbon atoms. Each X is independently a group represented by Formula (X1), Formula (X2), or Formula (X3). When an average number of groups represented by Formula (X1), an average number of groups represented by Formula (X2), and an average number of groups represented by Formula (X3) per molecule of the compound represented by Formula (2) are respectively x₁, x₂, and x₃, x₁+2x₂+x₃=4r, 0<x₁<4r, 0≤x₂<2r, and 0<x₃<4r are satisfied. r is an average value satisfying being 1 to 100.

R³ is preferably alkyl and more preferably methyl.

x₁ preferably exceeds r and more preferably exceeds 2r. In addition, x₁ is preferably less than 3r. The above-described x₂ is preferably r or less. x₃ preferably exceeds r. In addition, x₃ is preferably less than 3r and more preferably less than 2r. x₁>x₃ is preferably satisfied. In one form, x₂ may be 0. At this time, r becomes 1.

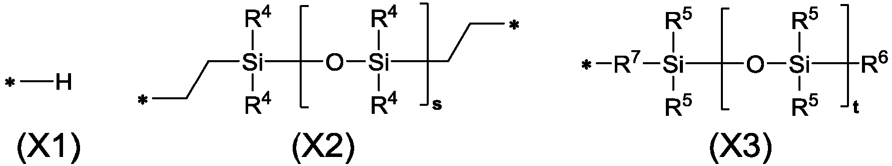

In Formula (X1), Formula (X2), and Formula (X3), * represents a bonding site.

In Formula (X2), each R⁴ is independently phenyl, cyclohexyl, cyclopentyl, or alkyl having 1 to 4 carbon atoms. s is an average value satisfying being 2 to 20.

In Formula (X3), each R⁵ is independently phenyl, cyclohexyl, cyclopentyl, or alkyl having 1 to 4 carbon atoms. R⁶ is alkenyl having 2 to 5 carbon atoms. R⁷ is alkanediyl having the same number of carbon atoms as R⁶. t is an average value satisfying being 2 to 20.

R⁵ is preferably alkyl and more preferably methyl. The number of carbon atoms in R⁶ and R⁷ is preferably 2. The upper limit of t is preferably 10, more preferably 5, and still more preferably 3.

The compound represented by Formula (2) can be synthesized, for example, through a method disclosed in PCT International Publication No. WO2011/145638.

The lower limit of the content of the organosilicon compound (B 1) in all organosilicon compound in the thermosetting resin composition is preferably 10 mass% and more preferably 30 mass%, and in some cases, still more preferably 50 mass%. On the other hand, the upper limit of the content thereof is preferably 90 mass% and more preferably 70 mass%, and in some cases, still more preferably 50 mass%. By setting the content of the organosilicon compound (B1) to be within the above-described ranges, optimization or the like of the mixing ratio with other components lowers the viscosity of the thermosetting resin composition and further improves yellowing resistance of a molded body obtained through curing when exposed to high temperatures.

### <Organosilicon compound (B2)>

The organosilicon compound (B2) is the compound represented by Formula (3).

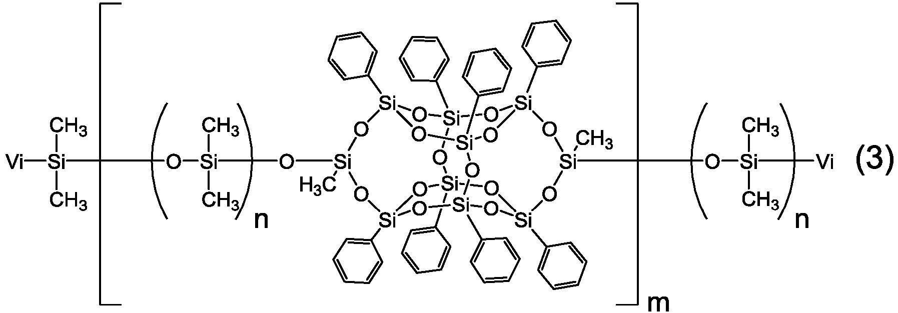

In Formula (3), m is an average value satisfying being 1 to 5, n is an average value satisfying being 2 to 50, and Vi represents vinyl.

The lower limit of the content of the organosilicon compound (B2) in all organosilicon compound in the thermosetting resin composition is preferably 0 mass% and more preferably 1 mass%, and in some cases, still more preferably 5 mass%. On the other hand, the upper limit of the content thereof is preferably 90 mass% and more preferably 70 mass%, and in some cases, still more preferably 50 mass%. By setting the content of the organosilicon compound (B2) to be within the above-described ranges, optimization or the like of the mixing ratio with other components lowers the viscosity of the thermosetting resin composition and further improves yellowing resistance of a molded body obtained through curing when exposed to high temperatures.

### <Organosilicon compound (B3)>

The organosilicon compound (B3) is the compound represented by Formula (4).

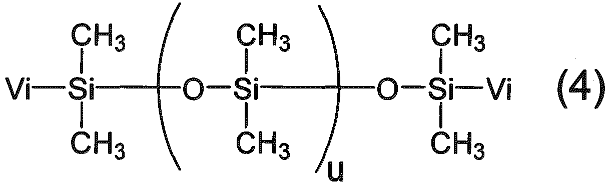

In Formula (4), u is an average value whereby 0≤u≤50 is satisfied, and Vi represents vinyl.

The lower limit of the content of the organosilicon compound (B3) in all organosilicon compound in the thermosetting resin composition is preferably 0.5 mass% and more preferably 1 mass%, and in some cases, still more preferably 3 mass% or 5 mass%. On the other hand, the upper limit of the content thereof is preferably 40 mass% and more preferably 30 mass%, and in some cases, still more preferably 25 mass% or 20 mass%. By setting the content of the organosilicon compound (B3) to 0.5 mass% to 40 mass%, optimization or the like of the mixing ratio with other components lowers the viscosity of the thermosetting resin composition and further improves yellowing resistance of a molded body obtained through curing when exposed to high temperatures.

It is preferable that a weight ratio of a content of the organosilicon compounds (A) and a content of the organosilicon compound (B) be 0.1 to 2.

In addition, regarding the content of each component in the thermosetting resin composition, the lower limit of a (vinyl-to-hydrosilyl) ratio of the number of moles of all vinyl in all the components to the number of moles of all hydrosilyl in all the components is preferably 0.6, more preferably 0.7, still more preferably 0.8, and still more preferably 0.9. Furthermore, this ratio is, in some cases, more preferably greater than 1. On the other hand, the upper limit of this ratio is preferably 1.6 and more preferably 1.4. In a case where the molar ratio of vinyl to hydrosilyl is within the above-described ranges, a cross-linking reaction can more effectively proceed, whereby the heat resistance or the like can be further increased.

### <Component (C): Hydrosilylation catalyst (C)>

The hydrosilylation catalyst (C) is not particularly limited as long as it is a catalyst that causes a hydrosilylation reaction between the organosilicon compounds (A) and the organosilicon compounds (B). Examples of such hydrosilylation catalysts include platinum catalysts such as chloroplatinic acid and Karstedt's catalysts.

The lower limit of the content of the hydrosilylation catalyst (C) in the thermosetting resin composition is, for example, 0.1 ppm and preferably 0.5 ppm. A reaction can be sufficiently caused by setting the content of the hydrosilylation catalyst (C) to 0.1 ppm or more. On the other hand, the upper limit of this content is, for example, 1,000 ppm, preferably 100 ppm, and more preferably 10 ppm or 3 ppm. The crack resistance, light transmittance, or the like of an obtained molded body can be improved by setting the content of the hydrosilylation catalyst (C) to 1,000 ppm or less.

### <Component (D): Adhesion-imparting agent (D)>

It is preferable that the thermosetting resin composition further contain an adhesion-imparting agent (D). The adhesion-imparting agent (D) is preferably an organosilicon compound having hydrosilyl and epoxy and more preferably one further having alkoxysilyl. Such a compound can undergo a bonding reaction with a base material or the like on which the thermosetting resin composition is stacked while undergoing a cross-linking reaction with other components in the thermosetting resin composition, and the adhesion of an obtained molded body can be enhanced. Furthermore, the adhesion-imparting agent (D) is more preferably one having a silsesquioxane structure from the viewpoint of heat resistance or the like. Examples of such a suitable adhesion-imparting agent (D) include a compound represented by Formula (5).

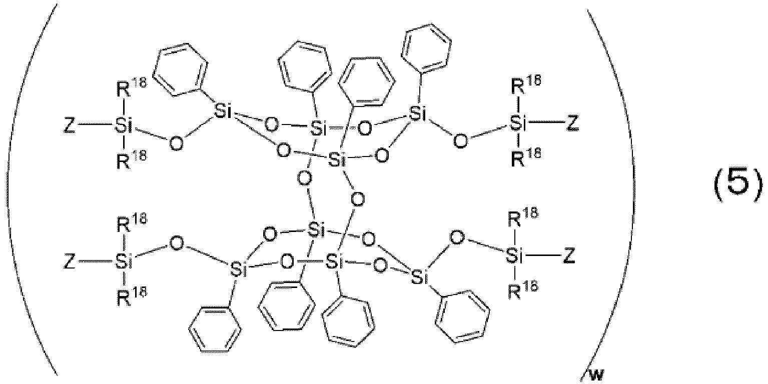

In Formula (5), each R¹⁸ is independently cyclohexyl, cyclopentyl, or alkyl having 1 to 4 carbon atoms. Each Z is independently a group represented by Formula (Z1), Formula (Z2), Formula (Z31), Formula (Z32), Formula (Z33), or Formula (Z41). When an average number of groups represented by Formula (Z1), an average number of groups represented by Formula (Z2), an average number of groups represented by Formula (Z31), Formula (Z32), or Formula (Z33), and an average number of groups represented by Formula (Z41) per molecule of the compound represented by Formula (5) are respectively z₁, z₂, z₃, and z₄, z₁+2z₂+z₃+z₄=4w, 0.5w≤z₁≤3w, 0.25w≤z₂≤w, 0.1w≤z₃≤2w, and 0≤z₄≤w are satisfied. w is an average value satisfying being 1 to 100.

R¹⁸ is preferably alkyl and more preferably methyl. It is preferable that z₁, z₂, z₃, and z₄ be respectively w≤z₁≤2w, 0.3w≤z₂≤w, 0.3w≤z3≤w, and 0.3w≤z₄≤w. The lower limit of w may be 3 or 5. In addition, the upper limit of w may be 30 or 15.

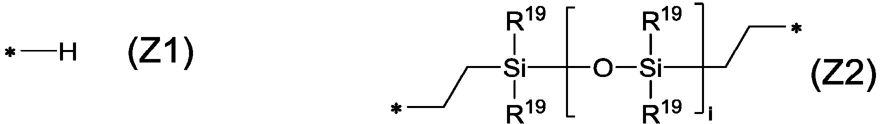

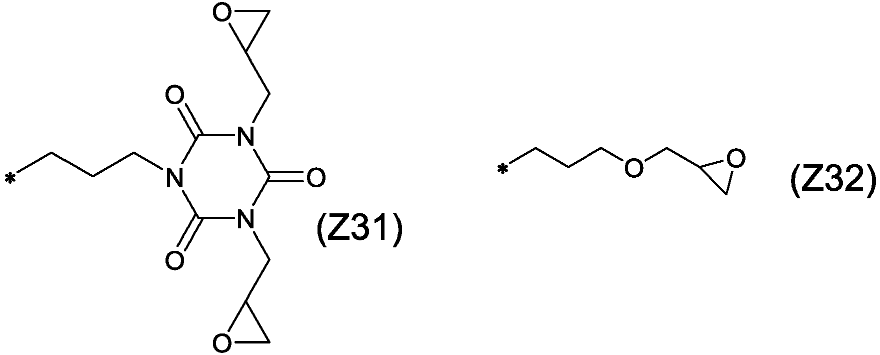

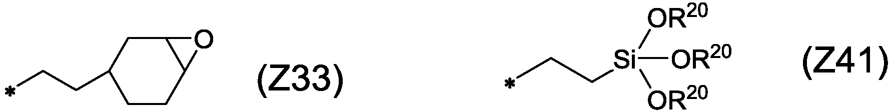

In Formula (Z1), Formula (Z2), Formula (Z31), Formula (Z32), Formula (Z33), and Formula (Z41), * represents a bonding site.

In Formula (Z2), each R¹⁹ is independently phenyl, cyclohexyl, cyclopentyl, or alkyl having 1 to 4 carbon atoms. i is an average value satisfying being 1 to 20. R¹⁹ is preferably alkyl and more preferably methyl.

In Formula (Z41), each R²⁰ is independently methyl, ethyl, butyl, or isopropyl. R²⁰ is preferably methyl.

The lower limit of the content of the adhesion-imparting agent (D) in the thermosetting resin composition is preferably 0.1 mass% and more preferably 1 mass%. Sufficient adhesion can be imparted by setting the content of the adhesion-imparting agent (D) to 0.1 mass% or more. On the other hand, the upper limit of the content thereof is preferably 10 mass%, more preferably 5 mass%, and still more preferably 3 mass%. By setting the content of the adhesion-imparting agent (D) to 10 mass% or less, optimization or the like of the mixing ratio with other components or the cross-linking density of an obtained molded body further improves crack resistance of molded body obtained through curing in a high-temperature environment. In addition, the adhesion-imparting agent (D) may be an organosilicon compound.

### <Component (E): Phosphor (E)>

### <Component (F): White pigment (F)>

It is preferable that the thermosetting resin composition further include: a phosphor (E) or a white pigment (F). The phosphor (E) or the white pigment (F) is usually dispersed and contained in the thermosetting resin composition. In the case where the thermosetting resin composition further contains the phosphor (E) or the white pigment (F), the thermosetting resin composition can be more suitably used as an encapsulant for optical semiconductor elements.

Examples of the phosphor (E) include inorganic phosphors such as YAG phosphors, TAG phosphors, and silicate phosphors or organic phosphors such as arylsulfoamide-melamine-formaldehyde co-condensation dyed materials and perylene phosphors.

Examples of the white pigment (F) include titanium oxide, alumina, barium titanate, magnesium oxide, antimony oxide, zirconium oxide, and inorganic hollow particles.

### <Other components>

The thermosetting resin composition may contain components other than the components (A) to (F). Examples of other components include fillers, flame retardants, ion adsorbents, antioxidants, curing retarders, curing inhibitors, and ultraviolet absorbents.

The contents of components other than the components (A) to (F) can be appropriately set according to uses or the like. On the other hand, in some cases, the contents of these other components are preferably small. The upper limit of the contents of components other than the components (A) to (F) in the thermosetting resin composition is 10 mass%, 1 mass%, or 0.1 mass%, and in some cases, preferably 0.01 mass%. On the other hand, the lower limit of the contents of components other than the components (A) to (F) may be, for example, 0.01 mass%, 0.1 mass%, or 1 mass%.

The thermosetting resin composition may or may not contain a solvent or other volatile components. However, since the organosilicon compounds (A) are usually liquids, favorable fluidity can be maintained without using a solvent. In addition, by making the composition substantially free of volatile components such as solvents, the organosilicon compounds (A) can be more suitably used as encapsulants for optical semiconductor elements. The upper limit of the contents of a solvent or volatile components in the thermosetting resin composition is preferably 1 mass%, more preferably 0.1 mass%, or more preferably 0.01 mass%.

### <Preparation method>

A preparation method for the thermosetting resin composition is not particularly limited. Examples of preparation methods for the thermosetting resin composition include a method for mixing components using a mixer such as a homo-disper, a homomixer, a universal mixer, a planetarium mixer, a kneader, three rolls, and a bead mill at normal temperature or under heating, for example, from 40°C to 100°C.

### <Use>

The thermosetting resin composition can be suitably used as an encapsulant for optical semiconductor elements, an encapsulant for other semiconductor elements, a material for forming an insulating film, a sealing material, an optical lens, and the like, and other adhesives, and the like. Among these, since a molded body obtained through curing has excellent crack resistance in a high-temperature environment and can have favorable light transmittance and light refraction properties, it can be particularly suitably used as an encapsulant for optical semiconductor elements.

### <Molded body>

A molded body according to one embodiment of the present invention is a molded body obtained by curing the thermosetting resin composition. That is, the molded body is a cured product of the thermosetting resin composition. One embodiment of the present invention also includes the cured product of the thermosetting resin composition. Examples of the molded body include an encapsulant for semiconductor elements such as optical semiconductor elements, an insulating film, a sealing material, and an optical lens, and among these, an encapsulant for optical semiconductor elements is preferable.

The molded body is obtained by curing the above-described thermosetting resin composition through heating. The heating temperature at this time is, for example, 60°C to 200°C and preferably 80°C to 160°C. In addition, the heating time can be set to, for example, 1 to 24 hours.

The light refractive index of the molded body is preferably 1.4 or more, more preferably 1.48 or more, and still more preferably 1.50 or more. In a case where the molded body has such a high refractive index, it has excellent efficiency of extracting light from an optical semiconductor element and is useful as an encapsulant for optical semiconductor elements. The upper limit of this light refractive index is, for example, 2, and may be 1.8, 1.7, or 1.6.

The light transmittance of the molded body at a wavelength of 400 nm is preferably 95% or more and more preferably 97% or more. In a case where the molded body has such a high light transmittance, it is more useful as an encapsulant for optical semiconductor elements. The upper limit of this light transmittance is, for example, 99.9%, and may be 99%.

The initial yellowness of the molded body is preferably 2.0 or less, more preferably 1.0 or less, and still more preferably less than 0.1.

### <Optical semiconductor device>

An optical semiconductor device according to one embodiment of the present invention includes an optical semiconductor element and the molded body for encapsulating the above-described optical semiconductor element.

The above-described optical semiconductor element is not particularly limited. For example, in a case where the above-described optical semiconductor element is an LED, examples thereof include one formed, for example, by stacking a semiconductor material on a substrate. In this case, examples of semiconductor materials include GaAs, GaP, GaAlAs, GaAsP, AlGaInP, GaN, InN, AlN, InGaAlN, and SiC.

The optical semiconductor device is obtained by encapsulating an optical semiconductor element using the thermosetting resin composition according to one embodiment of the present invention. Examples of such encapsulation methods include: (1) a method in which the thermosetting resin composition is previously injected into a mold frame, and a lead frame or the like to which an optical semiconductor element is fixed is immersed therein, followed by thermal curing; and (2) a method in which the thermosetting resin composition is injected into a frame into which an optical semiconductor element is inserted, followed by thermal curing. Examples of methods for injecting the thermosetting resin composition include injecting using a dispenser, transfer molding, and injection molding. Furthermore, examples of other encapsulation methods include a method for performing dropwise addition, printing, coating, and the like of the thermosetting resin composition onto an optical semiconductor element, followed by thermal curing.

Since the thermosetting resin composition according to one embodiment of the present invention is used as an encapsulant in the optical semiconductor device, the encapsulant has excellent crack resistance in a high-temperature environment. Accordingly, the optical semiconductor device has excellent durability even with a high output and a high power density. The optical semiconductor device can be used in various lighting devices, electronic bulletin boards, traffic lights, backlights of liquid crystal display devices, LED displays, and the like.

### [Examples]

The present invention will be described in more detail based on examples. However, the present invention is not limited to the following examples. "Vi" in chemical formulae represents vinyl. Hereinafter, a method for analyzing a synthesized organosilicon compound will be shown.

### <NMR (nuclear magnetic resonance spectrum)>

A 500 MHz NMR measurement device manufactured by JEOL Ltd. was used to measure ¹H-NMR by dissolving a measurement sample in heavy acetone (manufactured by FUJIFILM Wako Chemical Corporation) and to measure ²⁹Si-NMR by dissolving a measurement sample in tetrahydrofuran (manufactured by FUJIFILM Wako Chemical Corporation). In addition, the average siloxane chain length and the Vi equivalent introduced in a synthesized organosilicon compound derivative were determined from the integration proportion of ¹H-NMR or ²⁹Si-NMR.

### <Viscosity>

A cone-plate type TV-22 viscometer manufactured by Toki Sangyo Co., Ltd. was used to measure the viscosity at a thermostatic bath temperature of 25°C.

### <Synthesis of organosilicon compound (7-1)>

An organosilicon compound represented by Formula (7-1) was synthesized through a method disclosed in Japanese Patent No. 5704168.

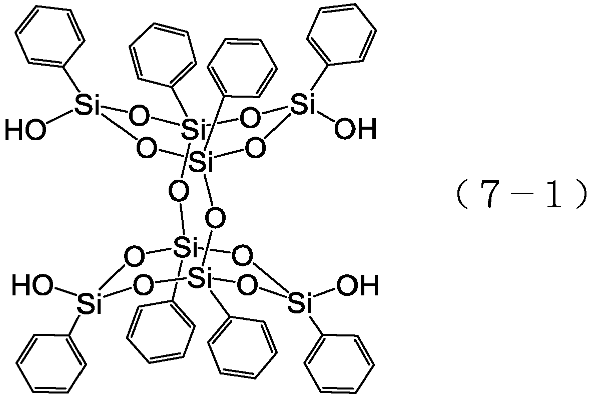

### <Synthesis of organosilicon compound (7-2)>

An organosilicon compound represented by Formula (7-2) was synthesized through a method disclosed in Japanese Patent No. 4379120.

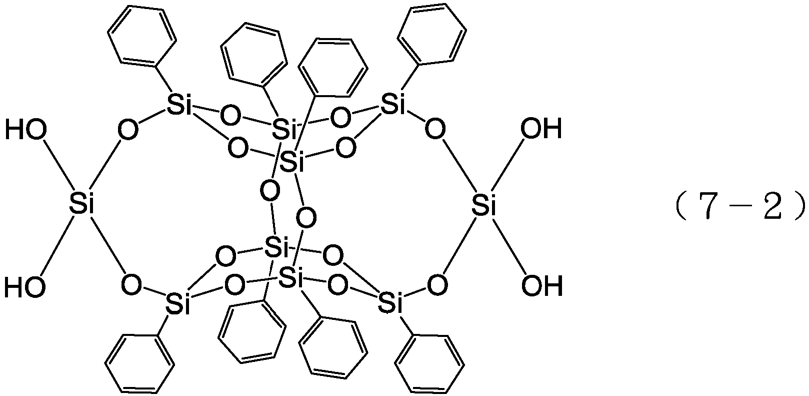

In addition, reagents and the like used in synthesizing the following organosilicon compounds are shown below.
· Hexamethylcyclotrisiloxane (manufactured by Tokyo Chemical Industry Co., Ltd.)
· Vinyldimethylchlorosilane (manufactured by Tokyo Chemical Industry Co., Ltd.)

### [Synthesis Example 1]

### <Synthesis of organosilicon compound (A1-1)>

78.6 g of hexamethylcyclotrisiloxane, 94.3 g of toluene, 28.4 g of vinyldimethylchlorosilane, and 18.8 g of N,N-diethylformamide were stirred at room temperature for 23 hours in a nitrogen atmosphere. Subsequently, 35.0 g of the compound (7-1), 86.0 g of toluene, and 30.6 g of triethylamine were added thereto and stirred for 6 hours. Furthermore, 6.3 g of vinyldimethylchlorosilane was added thereto and stirred for 3 hours. The obtained reaction solution was washed with pure water, a 3% aqueous acid solution, and saturated sodium bicarbonate water, and then low-boiling point components were distilled off to obtain 71.5 g of a liquid product.

From analysis results of the product, it was found that the product was an organosilicon compound (A1-1) with n average of 5.6.

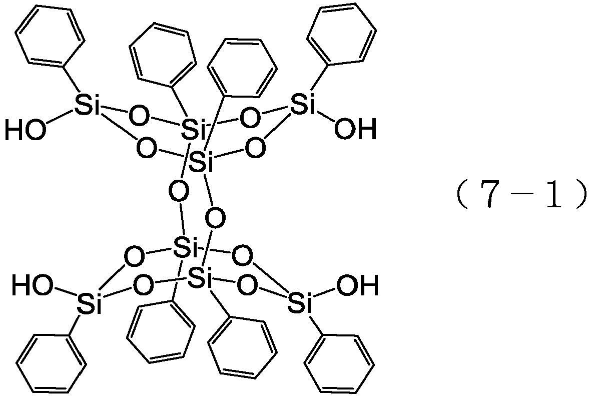

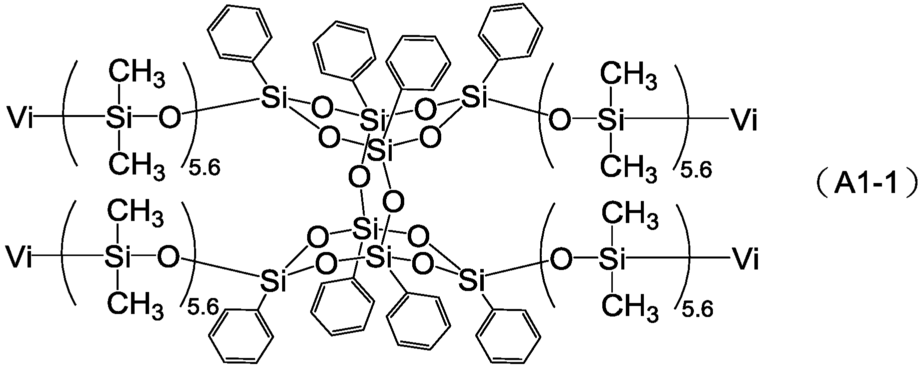

### <Organosilicon compound (A1-1)>

### (Analysis results)

¹H-NMR: δ (ppm): 7.70 to 7.00, 6.16 to 5.73, 0.36 to -0.31.
²⁹Si-NMR: δ (ppm): -0.9, -4.1 to -4.3, -19.5 to -22.3, -75.5 to -78.9.
Vi equivalent: 770
Viscosity: 332 mPa·s

### [Synthesis Example 2]

### <Synthesis of organosilicon compound (A2-1)>

41.2 g of hexamethylcyclotrisiloxane, 49.5 g of toluene, 12.4 g of vinyldimethylchlorosilane, and 10.4 g of N,N-diethylformamide were stirred at room temperature for 23 hours in a nitrogen atmosphere. 17.0 g of the compound (7-2), 180.9 g of toluene, and 10.9 g of triethylamine were added thereto and stirred for 3 hours. The obtained reaction solution was washed with pure water, a 3% aqueous acid solution, and saturated sodium bicarbonate water, and then low-boiling point components were distilled off to obtain 32.7 g of a liquid product.

From analysis results of the product, it was found that the product was an organosilicon compound (A2-1) with n average of 5.4.

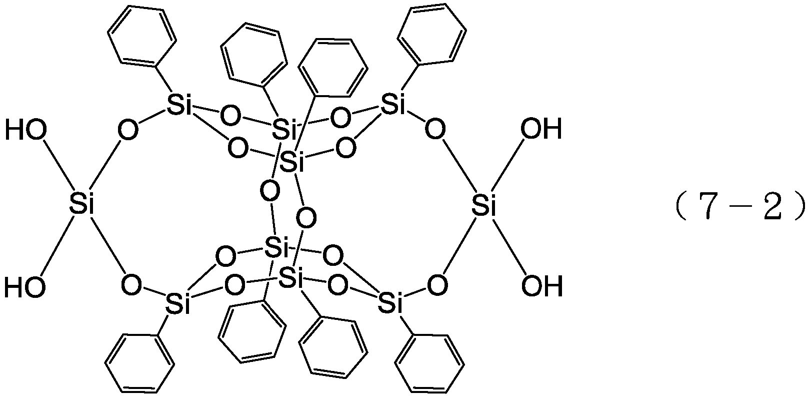

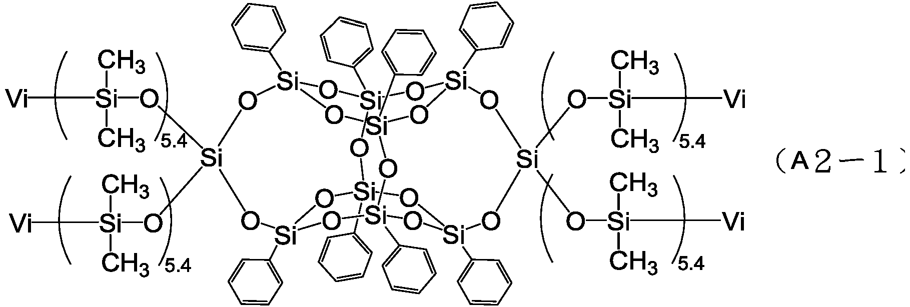

### <Organosilicon compound (A2-1)>

### (Analysis results)

¹H-NMR: δ (ppm): 7.67 to 7.21, 6.16 to 5.70, 0.28 to -0.18.
²⁹Si-NMR: δ (ppm): -0.8, -4.1 to -4.2, -17.2 to -22.3, -79.0 to -79.3, -108.3 to - 109.6.
Vi equivalent: 940
Viscosity: 317 mPa·s

### [Synthesis Example 3]

### <Synthesis of organosilicon compound (A2-2)>

34.3 g of hexamethylcyclotrisiloxane, 41.2 g of toluene, 12.5 g of vinyldimethylchlorosilane, and 8.24 g of N,N-diethylformamide were stirred at room temperature for 23 hours in a nitrogen atmosphere. 17.0 g of the compound (7-2), 68.4 g of toluene, and 13.4 g of triethylamine were added thereto and stirred for 4 hours. Furthermore, 3.1 g of vinyldimethylchlorosilane was added thereto and stirred for 2 hours. The obtained reaction solution was washed with pure water, a 3% aqueous acid solution, and saturated sodium bicarbonate water, and then low-boiling point components were distilled off to obtain 32.6 g of a liquid product.

From analysis results of the product, it was found that the product was an organosilicon compound (A2-2) with n average of 4.7.

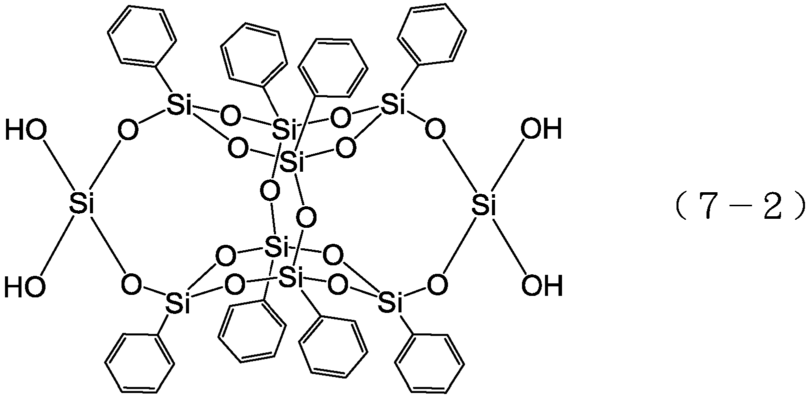

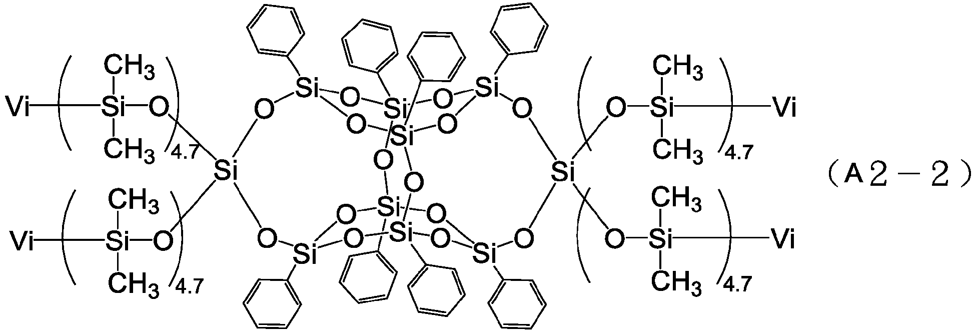

### <Organosilicon compound (A2-2)>

### (Analysis results)

¹H-NMR: δ (ppm): 7.67 to 7.04, 6.11 to 5.75, 0.12 to -0.39.
²⁹Si-NMR: δ (ppm): -0.8 to -0.9, -4.1 to -4.2, -19.9 to -22.3, -79.0 to -79.3, - 108.4 to -109.6.
Vi equivalent: 790
Viscosity: 372 mPa·s

Components other than the above-described synthesized organosilicon compound (organosilicon compound (A)) which are used in preparation of the following thermosetting resin composition are shown below.

### <Organosilicon compound (B)>

### · B1: Organosilicon compound represented by Formula (B1-1)

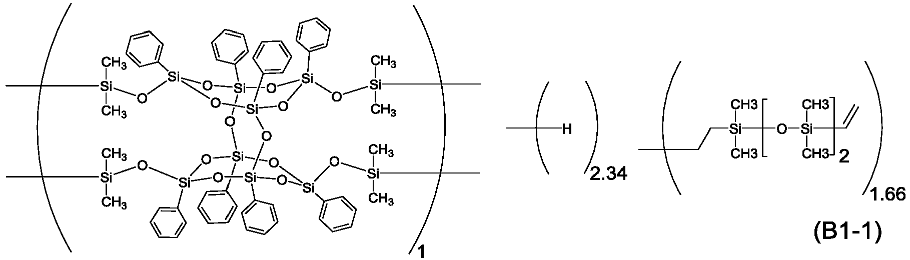

(Compound in which R³ is methyl and r is 1 in Formula (2), R⁵ is methyl, R⁶ is vinyl, R⁷ is ethane-1,2-diyl, and t is 2 in Formula (X3), x₁ [Formula (X1)]=2.34, x₂ [Formula (X2)]=0, and x₃ [Formula (X3)]=1.66)

This organosilicon compound (B1-1) was synthesized through the method disclosed in PCT International Publication No. WO2011/145638.

### · B2: Organosilicon compound represented by Formula (B2-1)

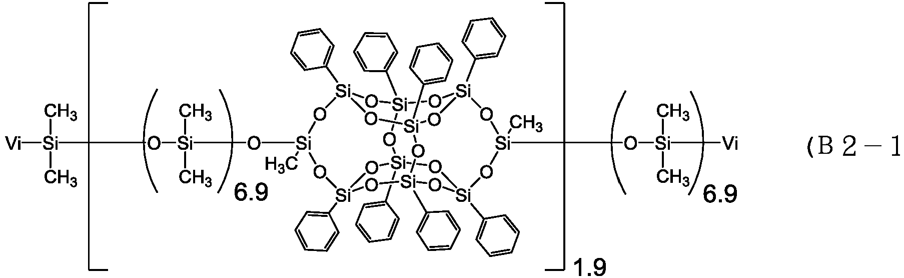

### (Compound in which n=6.9 and m=1.9 in Formula (3))

This organosilicon compound (B2-1) was synthesized through a method disclosed in Japanese Patent Laid-Open No. 2018-227629.

### · B3-1: Compound represented by Formula (B3-1) (DVTS: manufactured by JNC Corporation)

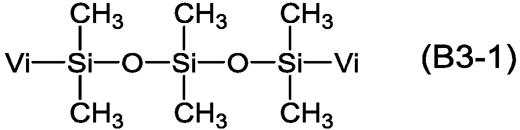

### (Compound in which u=1 in Formula (4))

### · B3-2: Compound represented by Formula (B3-2) (product name of "FM-2205": manufactured by JNC Corporation)

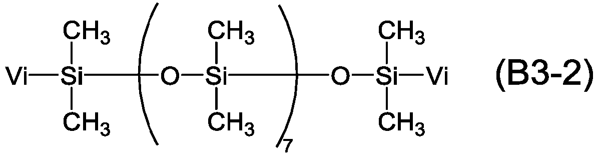

### <Hydroxylation catalyst (C)>

### · C-1: Karstedt's catalyst (product name of "Pt-VTS-3.0X": 3 wt% xylene solution manufactured by Unicore S.A.)

### <Adhesion-imparting agent (D)>

### · D-1: Compound represented by Formula (D-1)

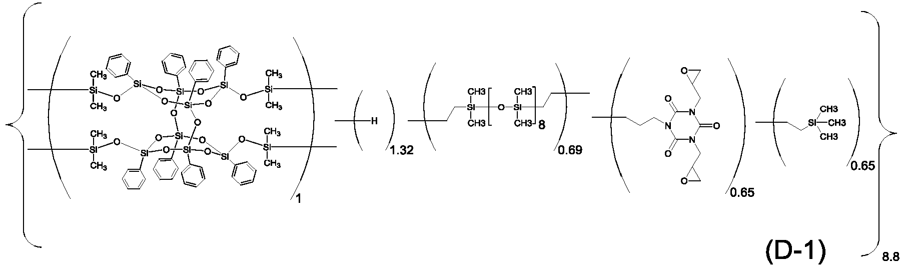

(Compound in which R¹⁸ is methyl and w is 8.8 in Formula (5), R¹⁹ in Formula (Z2) is methyl, R²⁰ in Formula (Z41) is methyl, z₁ [Formula (Z1)]=1.32w, z₂ [Formula (Z2)]=0.69w, z₃ [Formula (Z31)]=0.65w, and z₄ [Formula (Z41)]=0.65w)
This adhesion-imparting agent (D-1) was synthesized through a method disclosed in Japanese Patent No. 5880556.

### <Other components>

· Curing retarder: 1,3,5,7-tetravinyl-1,3,5,7-tetramethylcyclotetrasiloxane (MVS-H: manufactured by Gelest, Inc.)
· Curing inhibitor: 1-ethynylcyclohexanol (ECYH-OH: manufactured by Tokyo Chemical Industry Co., Ltd.)

### [Comparative Examples]

### <Organosilicon compound (Comparison-1)>

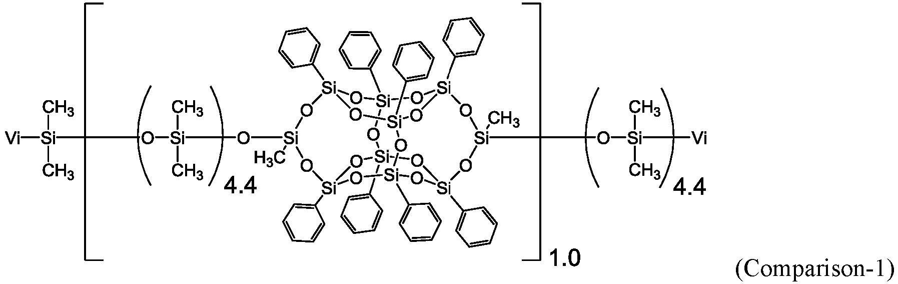

Vi equivalent: 1130

### [Composition Comparative Examples 1 to 4 and Composition Comparative Examples 1 to 8]

Resin compositions were prepared according to the formulation shown in Table 1 and heated at 150°C for 2 hours through the following method to obtain cured products.

### <Property evaluation of compositions and cured products>

4 mm-thick cured product: 4 mm-diameter Naflon SP packing (manufactured by NICHIAS Corporation) was sandwiched between two sheets of glass as a spacer, and each resin composition was poured thereinto. Subsequently, the resin composition was heat-cured, and the glass sheets were peeled off to obtain a cured product with a thickness of 4 mm and a smooth surface.

0.5 to 1 mm-thick cured product: A 0.5 to 1 mm-thick SUS plate was sandwiched between two sheets of glass as a spacer, and each resin composition was poured thereinto. Subsequently, the resin composition was heat-cured, and the glass sheets were peeled off to obtain a cured product with a thickness of 0.5 to 1 mm and a smooth surface.

0.1 mm-thick cured product: Slide glass (S9213 (thickness of 1.3 mm): manufactured by Matsunami Glass Ind., Ltd.) was coated using an applicator. Subsequently, the resin composition was heat-cured to obtain a cured product with a smooth surface.

The properties of the obtained compositions and cured products were evaluated through the following methods.

### <Viscosity>

An E-type rotational viscometer (TV-25: manufactured by Toki Sangyo Co., Ltd.) was used to measure the viscosity (25°C) of each composition liquid.

### <Light transmittance>

Each 4 mm-thick cured product was measured for the light transmittance at a wavelength of 400 nm using an ultraviolet visible spectrophotometer (V-650: manufactured by JASCO Corporation).

### <Initial yellowness>

An ultraviolet visible spectrophotometer (V-650: manufactured by JASCO Corporation) was used to obtain a tristimulus value (XYZ) of each 4 mm-thick cured product under standard illuminant D65 within a wavelength range of 200 to 800 nm, and the initial yellowness (YI0) was calculated by Equation "YI=100 (1.2985X-1.1335Z/Y" in accordance with JIS K7373 (2006).

### <Hardness>

Each 4 mm-thick cured product was measured using an automatic hardness tester (GX-610II: manufactured by Teclock) in accordance with JIS K6301 (type D).

### <Light refractive index>

Each plate-like test piece of 30 mm × 10 mm × 4 mm thick was prepared, and the light refractive index at one point of the above-described test piece was measured using the D line of a sodium lamp with an Abbe refractometer (NAR-2T: manufactured by Atago Co., Ltd.). 1-Bromonaphthalene (manufactured by Wako Pure Chemical Industries, Ltd.) was used as an intermediate solution.

### <DMA>

A plate-like test piece of 30 mm × 10 mm × 0.5 mm-thick was prepared, and the temperature at the maximum point of a loss coefficient (tan δ=E"/E') which was represented by the quotient of a storage elastic modulus (E') and a loss elastic modulus (E") and obtained through measurement using a dynamic viscoelasticity measurement device (DMS6100: manufactured by Hitachi High-Tech Corporation) under the following conditions was obtained.
Measurement temperature: -100°C to 250°C (temperature increase rate: 10°C min)
Measurement frequency: 10 Hz

### <Water vapor permeation>

A test piece of 70 mmφ × 1 mm-thick was prepared and measured based on a cup method using the following device under the following test conditions according to JIS Z-0208 (1976).
Device: Small environmental tester (SH-242: manufactured by Espec Corp.)
Test conditions: 40°C, 90%RH

### <Tensile test>

A strip-shaped test piece (50 mm length × 5 mm width × 0.5 mm thick) was prepared and subjected to a tensile test using a static material tester (RTF-1310: manufactured by A&D Company, Limited) at a tensile speed of 5 mm/min at 25°C to measure the elongation at break (Ea) and the stress at break (Sa).

### <Transmittance retention rate>

Each 4 mm-thick cured product was heated at 200°C in an air atmosphere for 1008 hours. The transmittance retention rate was obtained from the ratio (Tb/Ta × 100) of the light transmittance (Tb) after 1008 hours to the light transmittance (Ta) at a wavelength of 400 nm before heating.

### <Crack resistance test>

Each 0.1 mm-thick cured product was heated at 250°C in an air atmosphere. The cured product during heating was taken out every 168 hours and returned to room temperature, after which the appearance was observed and the time at which cracks occur was recorded.

### <Heat-resistant yellowness>

Each 4 mm-thick cured product was heated at 200°C in an air atmosphere for 1008 hours. The yellowness (YI) after heating for 1008 hours was measured in accordance with JIS K7373 (2006).

**Table 1. Composition of resin compositions and property evaluation result 1 of cured products**

| Component | | | Unit | Composition Comparative Example 1 | Composition Example 1 | Composition Example 2 |
|---|---|---|---|---|---|---|
| Composition | (A) | A1-1 | mass% | 0.0 | 9.6 | 0.0 |
| | | A2-2 | mass% | 0.0 | 0.0 | 9.5 |
| | (B) | B1-1 | mass% | 78.3 | 76.0 | 76.2 |
| | | B3-1 | mass% | 3.4 | 2.4 | 2.4 |
| | | B3-2 | mass% | 15.9 | 9.6 | 9.5 |
| | (C) | C-1 | ppm | 38 | 38 | 38 |
| | (D) | D-1 | mass% | 2.4 | 2.3 | 2.4 |
| | Curing retarder | | ppm | 340 | 340 | 340 |
| | Curing inhibitor | | ppm | 100 | 100 | 100 |
| | Total | | mass% | 100.0 | 100.0 | 100.0 |
| Evaluation | Viscosity | | mPa·s | 1,390 | 2,810 | 2,820 |
| | Light transmittance | | % | 99.1 | 97.8 | 98.9 |
| | Initial yellowness | | % | 0.3 | 0.4 | 0.3 |
| | HAZE | | | 0.4 | 0.3 | 0.4 |
| | Hardness (Shore D) | | - | 44 | 59 | 62 |
| | Refractive index | | nD25 | 1.5 | 1.50 | 1.51 |
| | DMA | | °C | 65.0 | 78.0 | 79.1 |
| | Stress at break | | MPa | 3.0 | 8.8 | 8.7 |
| | Elongation | | % | 34 | 22 | 20 |
| | WVTR | | g/m2·day | 25 | 21 | 21 |
| | Transmittance retention rate | | % | 64.3 | 81.9 | 79.8 |
| | Crack resistance | | hr | 504 | 1008 | 672 |
| | Heat-resistant yellowness | | % | 9.5 | 5.0 | 5.4 |

As shown in Table 1, Examples 1 and 2 containing an organosilicon compound (A1) or an organosilicon compound (A2) had a high stress at break, high gas barrier properties, and excellent heat-resistant transmittance retention rate, crack resistance, and heat-resistant yellowness while maintaining high hardness compared to Comparative Example 1 that does not contain a component (A).

**Table 2. Composition of resin compositions and property evaluation result 2 of cured products**

| Component | | | Unit | Composition Comparative Example 2 | Composition Example 3 | Composition Example 4 |
|---|---|---|---|---|---|---|
| Composition | (A) | A1-1 | mass% | 0.0 | 14.7 | 0.0 |
| | | A2-2 | mass% | 0.0 | 0.0 | 15.5 |
| | (B) | B1-1 | mass% | 59.0 | 63.1 | 61.7 |
| | | B2-1 | mass% | 34.0 | 14.7 | 15.5 |
| | | B3-1 | mass% | 1.2 | 1.3 | 1.3 |
| | | B3-2 | mass% | 4.1 | 4.3 | 4.2 |
| | (C) | C-1 | ppm | 30 | 30 | 30 |
| | (D) | D-1 | mass% | 1.8 | 2.0 | 1.9 |
| | Curing retarder | | ppm | 270 | 270 | 270 |
| | Curing inhibitor | | ppm | 100 | 100 | 100 |
| | Total | | mass% | 100.0 | 100.0 | 100.0 |
| Evaluation | Viscosity | | mPa·s | 8,900 | 6,220 | 5,160 |
| | Light transmittance | | % | 96.7 | 98.8 | 99.6 |
| | Initial yellowness | | % | *0.5* | 0.1 | 0.0 |
| | HAZE | | | 1.1 | *0.5* | 0.7 |
| | Hardness (Shore D) | | - | 52 | 55 | 51 |
| | Refractive index | | nD25 | 1.51 | 1.51 | 1.52 |
| | DMA | | °C | 85.7 | 78.5 | 73.5 |
| | Transmittance retention rate | | % | 83.9 | 82.9 | 82.2 |
| | Crack resistance | | hr | 840 | 840 | 672 |
| | Heat-resistant yellowness | | % | 3.8 | 4.4 | 4.6 |

As shown in Table 2, Examples 3 and 4 containing an organosilicon compound (A1) or an organosilicon compound (A2) were excellent in that they had a low viscosity while maintaining the high hardness, heat-resistant transmittance retention rate, crack resistance, and heat-resistant yellowness at the same levels as those in Comparative Example 2.

**Table 3. Composition of resin compositions and property evaluation result 3 of cured products**

| Component | | | Unit | Composition Comparative Example 3 | Composition Example 5 | Composition Example 6 | Composition Comparative Example 4 | Composition Example 7 | Composition Example 8 |
|---|---|---|---|---|---|---|---|---|---|
| Composition | (A) | A1-1 | mass% | 0.0 | 28.8 | 0.0 | 0.0 | 23.3 | 0.0 |
| | | A2-2 | mass% | 0.0 | 0.0 | 27.5 | 0.0 | 0.0 | 25.4 |
| | Comparison-1 | | mass% | 35.4 | 0.0 | 0.0 | 29.2 | 0.0 | 0.0 |
| | (B) | B1-1 | mass% | 60.7 | 67.0 | 68.2 | 63.2 | 68.5 | 66.6 |
| | | B3-1 | mass% | 1.9 | 2.1 | 2.2 | 1.3 | 1.4 | 1.4 |
| | | B3-2 | mass% | 0.0 | 0.0 | 0.0 | 4.3 | 4.7 | 4.6 |
| | (C) | C-1 | ppm | 38 | 38 | 38 | 30 | 30 | 30 |
| | (D) | D-1 | mass% | 1.9 | 2.1 | 2.1 | 2.0 | 2.1 | 2.1 |
| | Curing retarder | | ppm | 340 | | 340 | 270 | 270 | 270 |
| | Curing inhibitor | | ppm | 100 | 100 | 100 | 100 | 100 | 100 |
| | Total | | mass% | 100.0 | 100.0 | 100.0 | 100.0 | 100.0 | 100.0 |
| Evaluation | Viscosity | | mPa·s | 16,350 | 7,820 | 7,240 | 8,950 | 5,070 | 3,770 |
| | Light transmittance | | % | 43.0 | 96.5 | 98.6 | 58.4 | 98.9 | 99.1 |
| | Initial yellowness | | % | 26.7 | 0.8 | 0.5 | 17.5 | 0.2 | 0.0 |
| | HAZE | | | 26.9 | 0.7 | 0.6 | 17.9 | 0.5 | 0.4 |
| | Hardness (Shore D) | | - | 66 | 63 | 64 | 62 | 60 | 53 |
| | Refractive index | | nD25 | 1.53 | 1.51 | 1.51 | 1.52 | 1.51 | 1.53 |
| | DMA | | °C | 96.0 | 92.8 | 113.0 | 82.7 | 87.4 | 77.8 |
| | Transmittance retention rate | | % | 98.6 | 83.7 | 79.7 | 92.4 | 82.6 | 82.4 |
| | Crack resistance Heat-resistant yellowness | | hr | 672 | 1008 | 1008 | 840 | 1008 | 672 |
| | | | % | 25.4 | 4.9 | 5.5 | 18.1 | 4.5 | 4.6 |

As shown in Table 3, Examples 5 to 8 containing an organosilicon compound (A1) or an organosilicon compound (A2) were excellent in that they have excellent transmittance, yellowness, and HAZE and further have a low viscosity while maintaining the hardness compared to Comparative Examples 3 and 4 containing the organosilicon compound (Comparison-1).

From the above, it is clear that the organosilicon compound of the present invention and the thermosetting resin composition containing the same have a viscosity adaptable to various processes and provide a cured product having excellent heat-resistant transparency, crack resistance, and heat yellowing resistance.

### [Industrial Applicability]

The organosilicon compound of the present invention and the thermosetting resin composition containing the same can be suitably used as an encapsulant for optical semiconductor elements, an encapsulant for other semiconductor elements, an insulating film, a sealing material, an optical lens, and the like.

## Claims

1. A thermosetting resin composition comprising:
a compound that is selected from among organosilicon compounds (A) represented by Formula (1-1) or Formula (1-2);
an organosilicon compound (B) that has a plurality of crosslinkable groups in its molecule and is other than the organosilicon compounds (A); and
a hydrosilylation catalyst (C),
wherein the organosilicon compound (B) contains a compound that is
crosslinkable with the organosilicon compounds (A), and 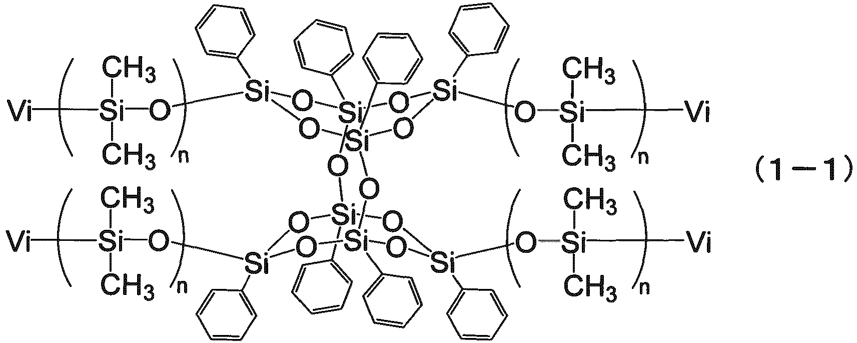 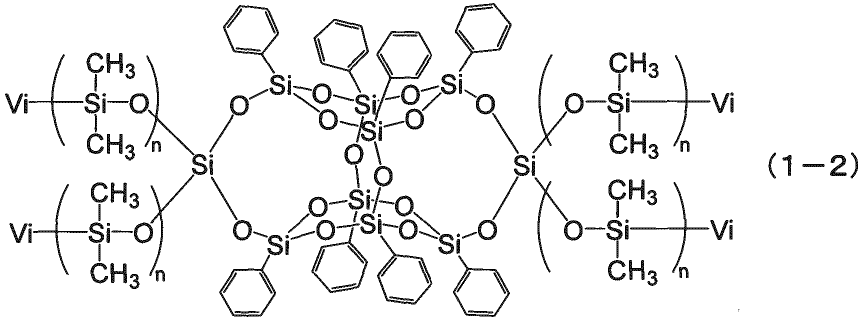
wherein, in Formula (1-1) and Formula (1-2), each n is independently an average value whereby 1<n≤10 is satisfied, and Vi represents vinyl.

2. The thermosetting resin composition according to claim 1,
wherein each n in the organosilicon compounds (A) is independently an average value whereby 3≤n≤7 is satisfied.

3. The thermosetting resin composition according to claim 1 or 2,
wherein the organosilicon compound (B) contains a compound represented by Formula (2), 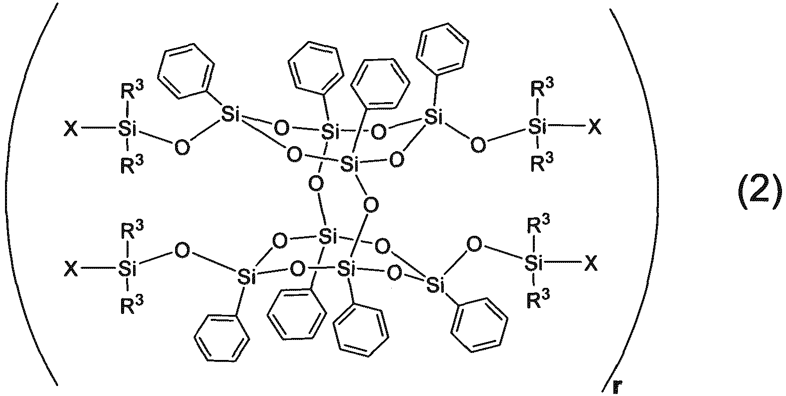
wherein, in Formula (2), each R³ is independently cyclohexyl, cyclopentyl, or alkyl having 1 to 4 carbon atoms, and each X is independently a group represented by Formula (X1), Formula (X2), or Formula (X3),
wherein, when an average number of groups represented by Formula (X1), an average number of groups represented by Formula (X2), and an average number of groups represented by Formula (X3) per molecule of the compound represented by Formula (2) are respectively x₁, x₂, and x₃, x₁+2x₂+x₃=4r, 0<x₁<4r, 0≤x₂<2r, and 0<x₃<4r are satisfied, and r is an average value satisfying being 1 to 100, 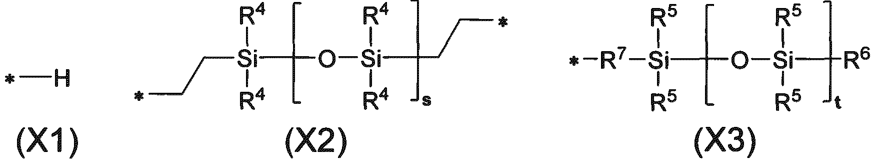
wherein, in Formula (X1), Formula (X2), and Formula (X3), * represents a bonding site,
wherein, in Formula (X2), each R⁴ is independently phenyl, cyclohexyl, cyclopentyl, or alkyl having 1 to 4 carbon atoms, and s is an average value satisfying being 2 to 20, and
wherein, in Formula (X3), each R⁵ is independently phenyl, cyclohexyl, cyclopentyl, or alkyl having 1 to 4 carbon atoms, R⁶ is alkenyl having 2 to 5 carbon atoms, R⁷ is alkanediyl having the same number of carbon atoms as R⁶, and t is an average value satisfying being 2 to 20.

4. The thermosetting resin composition according to claim 1 or 2,
wherein the organosilicon compound (B) contains a compound (B2) represented by Formula (3), and 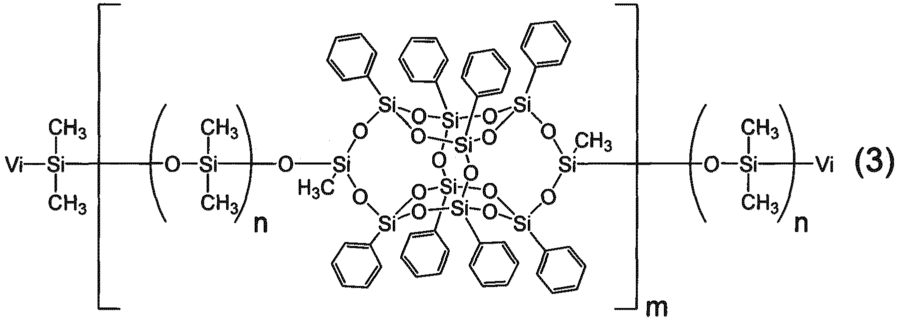
wherein, in Formula (3), m is an average value satisfying being 1 to 5, n is an average value satisfying being 2 to 50, and Vi represents vinyl.

5. The thermosetting resin composition according to claim 1 or 2,
wherein the organosilicon compound (B) contains a compound represented by Formula (4), and 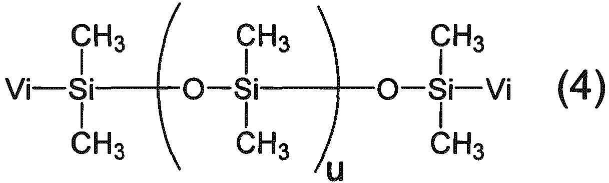
wherein, in Formula (4), u is an average value whereby 0≤u≤50 is satisfied, and Vi represents vinyl.

6. The thermosetting resin composition according to any one of claims 1 to 5,
wherein a content of the organosilicon compounds (A) is 5 mass% to 50 mass%.

7. The thermosetting resin composition according to any one of claims 1 to 5,
wherein a weight ratio of a content of the organosilicon compounds (A) and a content of the organosilicon compound (B) is 0.1 to 2.

8. The thermosetting resin composition according to any one of claims 1 to 7 further comprising:
an adhesion-imparting agent (D),
wherein the adhesion-imparting agent (D) contains a compound represented by Formula (5), 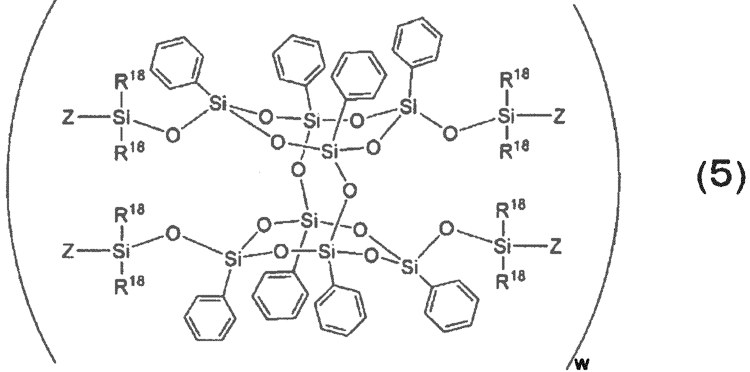
wherein, in Formula (5), each R¹⁸ is independently cyclohexyl, cyclopentyl, or alkyl having 1 to 4 carbon atoms, and each Z is independently a group represented by Formula (Z1), Formula (Z2), Formula (Z31), Formula (Z32), Formula (Z33), or Formula (Z41),
wherein, when an average number of groups represented by Formula (Z1), an average number of groups represented by Formula (Z2), an average number of groups represented by Formula (Z31), Formula (Z32), or Formula (Z33), and an average number of groups represented by Formula (Z41) per molecule of the compound represented by Formula (5) are respectively z₁, z₂, z₃, and z₄, z₁+2z₂+z₃+z₄=4w, 0.5w≤z₁≤3w, 0.5w≤2z₂≤2w, 0.1w≤z₃≤2w, and 0≤z₄≤w are satisfied, and w is an average value satisfying being 1 to 100, 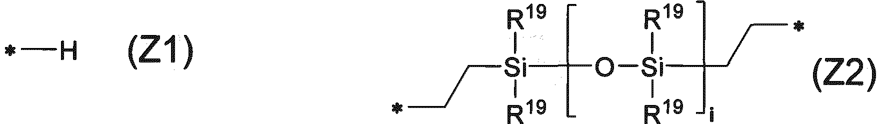 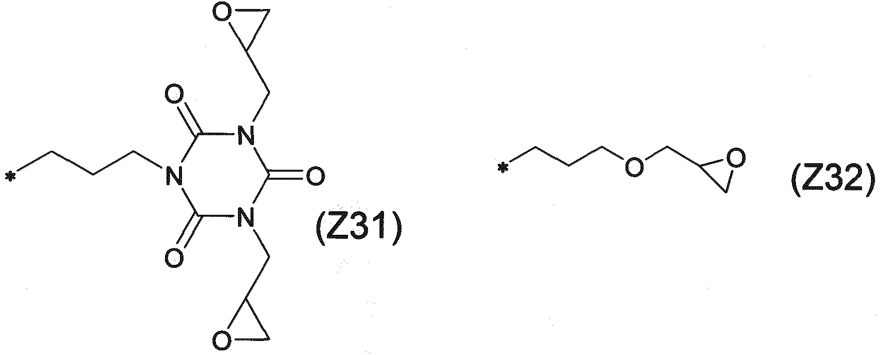 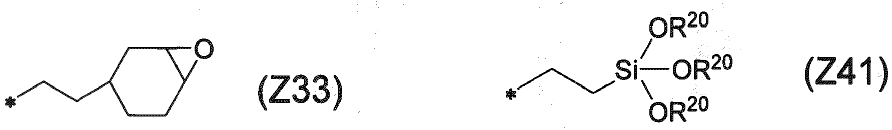
wherein, in Formula (Z1), Formula (Z2), Formula (Z31), Formula (Z32), Formula (Z33), and Formula (Z41), * represents a bonding site,
wherein, in Formula (Z2), each R¹⁹ is independently phenyl, cyclohexyl, cyclopentyl, or alkyl having 1 to 4 carbon atoms, and i is an average value satisfying being 1 to 20, and
wherein, in Formula (Z41), each R²⁰ is independently methyl, ethyl, butyl, or isopropyl.

9. The thermosetting resin composition according to claim 8,
wherein a content of the adhesion-imparting agent (D) is 0.1 mass% to 5 mass%.

10. The thermosetting resin composition according to any one of claims 1 to 9, further comprising:
a phosphor (E) or a white pigment (F).

11. A molded body obtained by curing the thermosetting resin composition according to any one of claims 1 to 10.

12. An optical semiconductor device comprising:
the molded body according to claim 11; and
an optical semiconductor element sealed by this molded body.

13. An organosilicon compound represented by Formula (1-2), 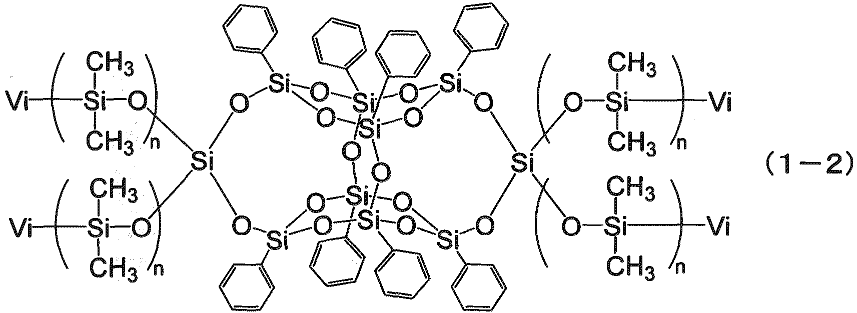 wherein, in Formula (1-2), each n is independently an average value whereby 1<n≤10 is satisfied, and Vi represents vinyl.

## Patentansprüche

1. Wärmehärtende Harzzusammensetzung, umfassend:
eine Verbindung, die ausgewählt ist aus den siliciumorganischen Verbindungen (A), dargestellt durch Formel (1-1) und Formel (1-2);
eine siliciumorganische Verbindung (B), die mehrere vernetzbare Gruppen in ihrem Molekül aufweist und von den siliciumorganischen Verbindungen (A) verschieden ist; und
einen Hydrosilylierungskatalysator (C),
wobei die siliciumorganische Verbindung (B) eine Verbindung enthält, die mit den siliciumorganischen Verbindungen (A) vernetzbar ist, und 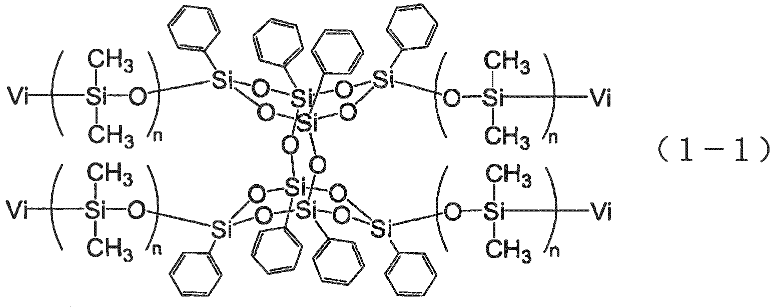 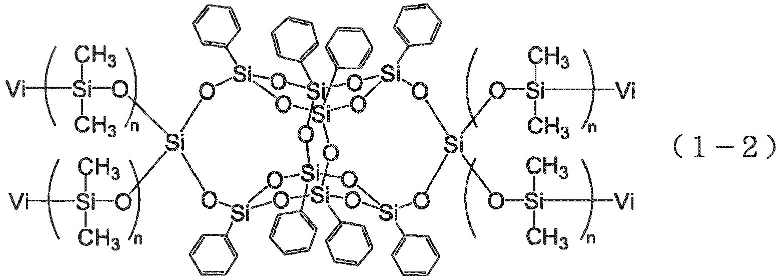
wobei in den Formeln (1-1) und (1-2) jedes n unabhängig für einen Durchschnittswert steht, wobei 1<n≤10 erfüllt ist, und Vi für Vinyl steht.

2. Wärmehärtende Harzzusammensetzung nach Anspruch 1,
wobei jedes n in den siliciumorganischen Verbindungen (A) unabhängig für einen Durchschnittswert steht, wobei 3≤n≤7 erfüllt ist.

3. Wärmehärtende Harzzusammensetzung nach Anspruch 1 oder 2,
wobei die siliciumorganische Verbindung (B) eine Verbindung enthält, die der Formel (2) entspricht, 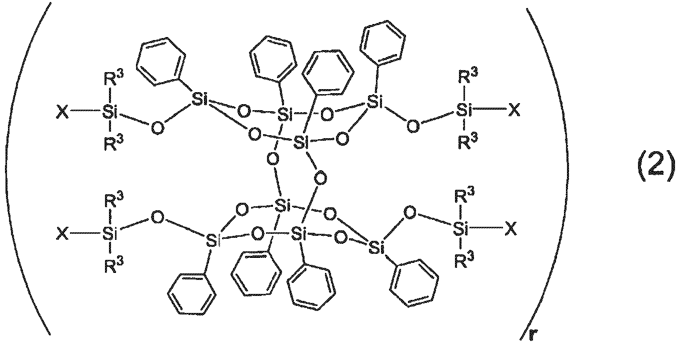
wobei in Formel (2) jedes R³ unabhängig für Cyclohexyl, Cyclopentyl oder Alkyl mit 1 bis 4 Kohlenstoffatomen steht und jedes X unabhängig für eine Gruppe steht, die durch Formel (X1), Formel (X2) oder Formel (X3) dargestellt wird,
wobei, wenn eine durchschnittliche Anzahl von Gruppen, die durch die Formel (X1) dargestellt werden, eine durchschnittliche Anzahl von Gruppen, die durch die Formel (X2) dargestellt werden, und eine durchschnittliche Anzahl von Gruppen, die durch die Formel (X3) dargestellt werden, pro Molekül der Verbindung, die durch die Formel (2) dargestellt wird, jeweils für x₁, x₂ und x₃ steht, x₁+2x₂+x₃=4r, 0<x₁<4r, 0≤x₂<2r und 0<x₃<4r erfüllt sind, und r für einen Durchschnittswert steht, der 1 bis 100 erfüllt, 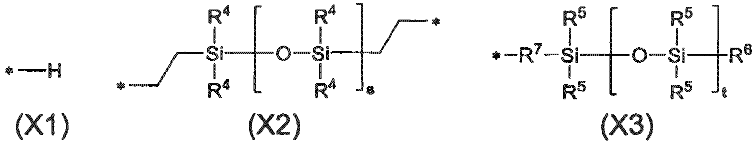
wobei in den Formeln (X1), (X2) und (X3) * für eine Bindungsstelle steht,
wobei in der Formel (X2) jedes R⁴ unabhängig für Phenyl, Cyclohexyl, Cyclopentyl oder Alkyl mit 1 bis 4 Kohlenstoffatomen steht und s für einen Durchschnittswert steht, der 2 bis 20 erfüllt, und
wobei in der Formel (X3) jedes R⁵ unabhängig für Phenyl, Cyclohexyl, Cyclopentyl oder Alkyl mit 1 bis 4 Kohlenstoffatomen steht, R⁶ für Alkenyl mit 2 bis 5 Kohlenstoffatomen steht, R⁷ für Alkandiyl mit der gleichen Anzahl von Kohlenstoffatomen wie R⁶ steht und t für einen Durchschnittswert steht, der 2 bis 20 erfüllt.

4. Wärmehärtende Harzzusammensetzung nach Anspruch 1 oder 2,
wobei die siliciumorganische Verbindung (B) eine Verbindung (B2) enthält, die durch die Formel (3) dargestellt wird, und 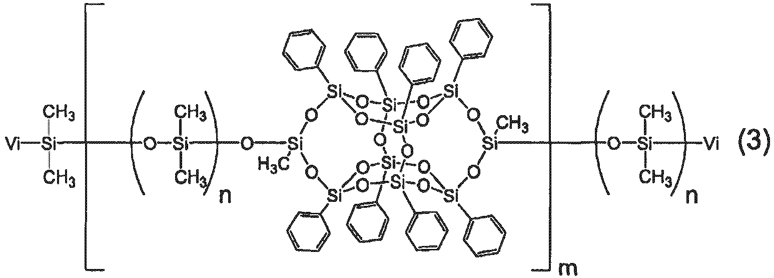
wobei in Formel (3) m für einen Durchschnittswert steht, der 1 bis 5 erfüllt, n für einen Durchschnittswert steht, der 2 bis 50 erfüllt, und Vi für Vinyl steht.

5. Wärmehärtende Harzzusammensetzung nach Anspruch 1 oder 2,
wobei die siliciumorganische Verbindung (B) eine Verbindung enthält, die durch die Formel (4) dargestellt wird, und 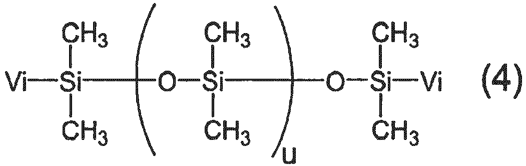
wobei in Formel (4) u für einen Durchschnittswert steht, wobei 0≤u≤50 erfüllt ist, und Vi für Vinyl steht.

6. Wärmehärtende Harzzusammensetzung nach einem der Ansprüche 1 bis 5,
wobei der Gehalt an siliciumorganischen Verbindungen (A) 5 Masse-% bis 50 Masse-% beträgt.

7. Wärmehärtende Harzzusammensetzung nach einem der Ansprüche 1 bis 5,
wobei das Gewichtsverhältnis des Gehalts an siliciumorganischen Verbindungen (A) und des Gehalts an siliciumorganischer Verbindung (B) 0,1 bis 2 beträgt.

8. Wärmehärtende Harzzusammensetzung nach einem der Ansprüche 1 bis 7, ferner umfassend:
ein haftvermittelndes Mittel (D),
wobei das haftvermittelnde Mittel (D) eine Verbindung enthält, die der Formel (5) entspricht, 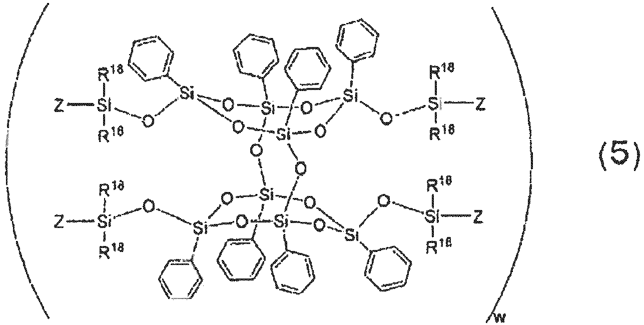
wobei in Formel (5) jedes R18 unabhängig für Cyclohexyl, Cyclopentyl oder Alkyl mit 1 bis 4 Kohlenstoffatomen steht und jedes Z unabhängig für eine Gruppe steht, die durch Formel (Z1), Formel (Z2), Formel (Z31), Formel (Z32), Formel (Z33) oder Formel (Z41) dargestellt wird,
wobei, wenn eine durchschnittliche Anzahl von Gruppen, die durch die Formel (Z1) dargestellt werden, eine durchschnittliche Anzahl von Gruppen, die durch die Formel (Z2) dargestellt werden, eine durchschnittliche Anzahl von Gruppen, die durch die Formel (Z31), die Formel (Z32) oder die Formel (Z33) dargestellt werden, und eine durchschnittliche Anzahl von Gruppen, die durch die Formel (Z41) dargestellt werden, pro Molekül der durch die Formel (5) dargestellten Verbindung jeweils z₁, z₂, z₃ und z₄ sind, z₁+2z₂+z₃+z₄=4w, 0,5≤z₁≤3w, 0,5w≤2₂2≤2w, 0,1w≤z₃≤2w, und 0≤z₄≤w erfüllt sind, und w für einen Durchschnittswert steht, der 1 bis 100 erfüllt, 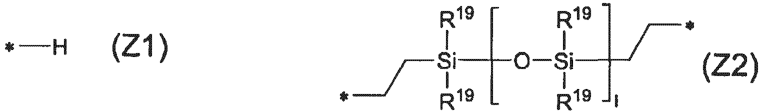 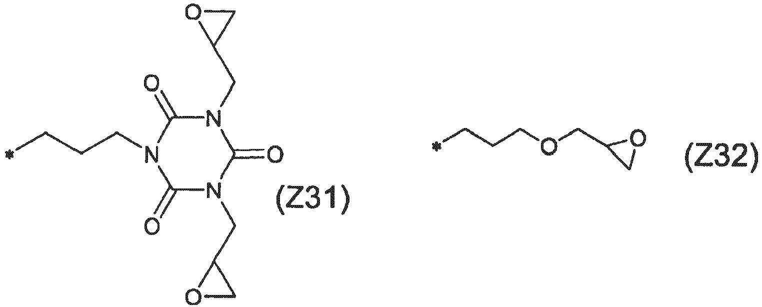 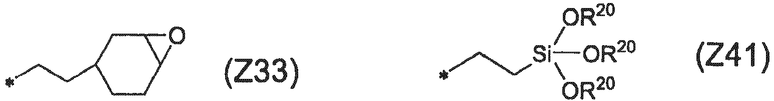
wobei in Formel (Z1), Formel (Z2), Formel (Z31), Formel (Z32), Formel (Z33) und Formel (Z41) * eine Bindungsstelle darstellt,
wobei in Formel (Z2) jedes R¹⁹ unabhängig für Phenyl, Cyclohexyl, Cyclopentyl oder Alkyl mit 1 bis 4 Kohlenstoffatomen steht und i für einen Durchschnittswert steht, der 1 bis 20 erfüllt, und wobei in Formel (Z41) jedes R20 unabhängig für Methyl, Ethyl, Butyl oder Isopropyl steht.

9. Wärmehärtende Harzzusammensetzung nach Anspruch 8,
wobei der Gehalt an Haftvermittler (D) 0,1 Masse-% bis 5 Masse-% beträgt.

10. Wärmehärtende Harzzusammensetzung nach einem der Ansprüche 1 bis 9, ferner umfassend:
einen Phosphor (E) oder ein Weißpigment (F).

11. Formkörper, erhalten durch Härten der wärmehärtenden Harzzusammensetzung nach einem der Ansprüche 1 bis 10.

12. Optische Halbleitervorrichtung, umfassend:
den Formkörper nach Anspruch 11; und
ein optisches Halbleiterelement, das durch diesen Formkörper versiegelt ist.

13. Siliciumorganische Verbindung, dargestellt durch die Formel (1-2), 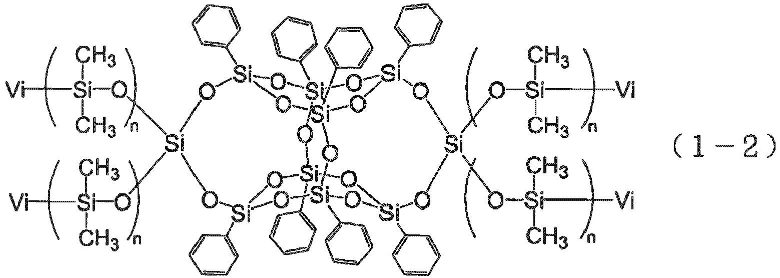 wobei in Formel (1-2) jedes n unabhängig für einen Durchschnittswert steht, wobei 1<n≤10 erfüllt ist, und Vi für Vinyl steht.

## Revendications

1. Composition de résine thermodurcissable comprenant :
un composé qui est choisi parmi les composés organosilicium (A) représentés par la formule (1-1) ou la formule (1-2) ;
un composé organosilicium (B) qui a une pluralité de groupes réticulables dans sa molécule et est différent des composés organosilicium (A) ; et
un catalyseur d'hydrosilylation (C),
le composé organosilicium (B) contenant un composé qui est réticulable avec les composés organosilicium (A) et 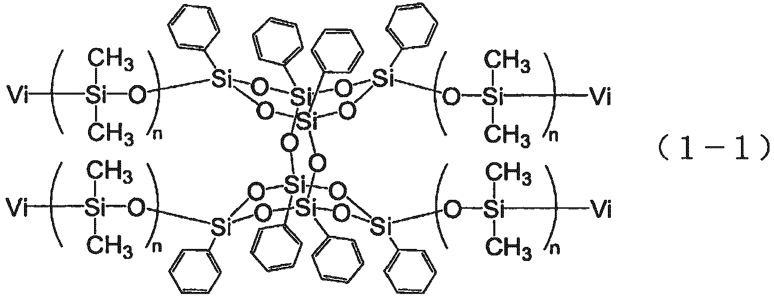 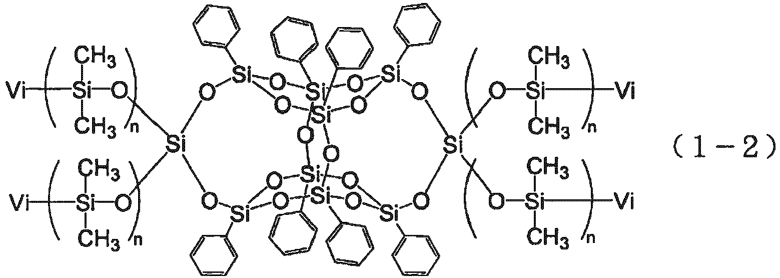
dans lesquelles, dans la formule (1-1) et la formule (1-2), chaque n est indépendamment une valeur moyenne moyennant quoi 1 < n ≤ 10 est satisfait et Vi représente un groupe vinyle.

2. Composition de résine thermodurcissable selon la revendication 1,
dans laquelle chaque n dans les composés organosilicium (A) est indépendamment une valeur moyenne moyennant quoi 3 ≤ n ≤ 7 est satisfait.

3. Composition de résine thermodurcissable selon la revendication 1 ou 2,
dans laquelle le composé organosilicium (B) contient un composé représenté par la formule (2), 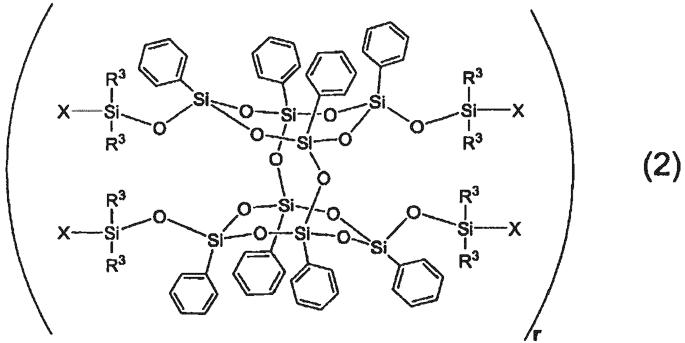
dans laquelle, dans la formule (2), chaque R³ est indépendamment un groupe cyclohexyle, cyclopentyle ou alkyle ayant 1 à 4 atomes de carbone et chaque X est indépendamment un groupe représenté par la formule (X1), la formule (X2) ou la formule (X3),
quand un nombre moyen de groupes représentés par la formule (X1), un nombre moyen de groupes représentés par la formule (X2) et un nombre moyen de groupes représenté par la formule (X3) par molécule du composé représenté par la formule (2) sont respectivement x₁, x₂ et x₃, x₁ + 2x₂ + x₃ = 4r, 0 < x₁ < 4r, 0 ≤ x₂ < 2r et 0 < x₃ < 4r sont satisfaits et r est une valeur moyenne satisfaisant étant comprise entre 1 et 100, 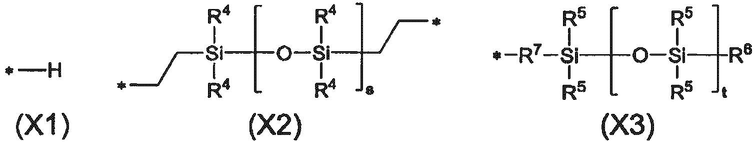
dans lesquelles, dans la formule (X1), la formule (X2 et la formule (X3), * représente un site de liaison,
dans la formule (X2), chaque R⁴ étant indépendamment un groupe phényle, cyclohexyle, cyclopentyle ou alkyle ayant 1 à 4 atomes de carbone et s est une valeur moyenne satisfaisant étant comprise entre 2 et 20 et
dans la formule (X3) chaque R⁵ étant indépendamment un groupe phényle, cyclohexyle, cyclopentyle ou alkyle ayant 1 à 4 atomes de carbone, R⁶ étant un groupe alcényle ayant 2 à 5 atomes de carbone, R⁷ étant un groupe alcanediyle ayant le même nombre d'atomes de carbone que R⁶ et t étant une valeur moyenne satisfaisant étant comprise entre 2 et 20.

4. Composition de résine thermodurcissable selon la revendication 1 ou 2,
dans laquelle le composé organosilicium (B) contient un composé (B2) représenté par la formule (3) et 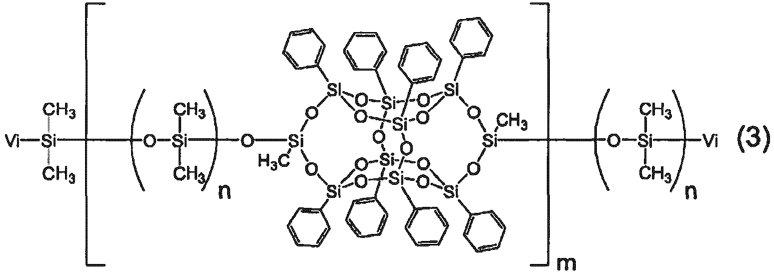
dans laquelle, dans la formule (3), m est une valeur moyenne satisfaisant étant comprise entre 1 et 5, n est une valeur moyenne satisfaisant étant comprise entre 2 à 50 et Vi représente un groupe vinyle.

5. Composition de résine thermodurcissable selon la revendication 1 ou 2,
dans laquelle le composé organosilicium (B) contient un composé représenté par la formule (4) et 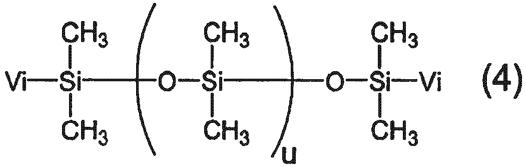
dans laquelle, dans la formule (4), u est une valeur moyenne moyennant quoi 0 ≤ u ≤ 50 est satisfait et Vi représente un groupe vinyle.

6. Composition de résine thermodurcissable selon l'une quelconque des revendications 1 à 5,
dans laquelle une teneur des composés organosilicium (A) est de 5 % en masse à 50 % en masse.

7. Composition de résine thermodurcissable selon l'une quelconque des revendications 1 à 5,
dans laquelle un rapport en poids d'une teneur des composés organosilicium (A) et d'une teneur en poids d'un composé organosilicium (B) est de 0,1 à 2.

8. Composition de résine thermodurcissable selon l'une quelconque des revendications 1 à 7,
comprenant en outre :
un agent impartissant une adhésion (D),
l'agent impartissant une adhésion (D) contenant un composé représenté par la formule (5), 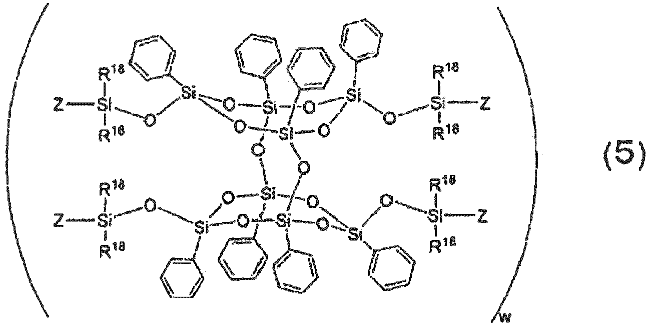
dans laquelle, dans la formule (5), chaque R¹⁸ est indépendamment un groupe cyclohexyle, cyclopentyle ou alkyle ayant 1 à 4 atomes de carbone et chaque Z est indépendamment un groupe représenté par la formule (Z1), la formule (Z2), la formule (Z31), la formule (Z32), la formule (Z33) ou la formule (Z41),
quand un nombre moyen de groupes représentés par la formule (Z1), un nombre moyen de groupes représenté par la formule (Z2), un nombre moyen de groupes représentés par la formule (Z31), la formule (Z32) ou la formule (Z33) et un nombre moyen de groupes représentés par la formule (Z41) par molécule du composé représenté par la formule (5) étant respectivement z₁, z₂, z₃ et z₄, z₁ + 2_{z2} + z₃ + z₄ = 4w, 0,5w ≤ z₁ ≤ 3w, 0,5w ≤ 2z₂ ≤ 2w, 0,1w ≤ z₃ ≤ 2w et 0 ≤ z₄ ≤ w sont satisfaits et w étant une valeur moyenne satisfaisant étant comprise entre 1 et 100, 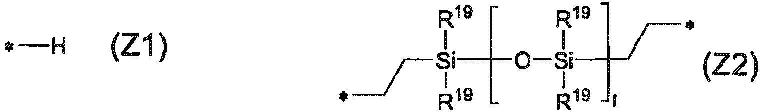 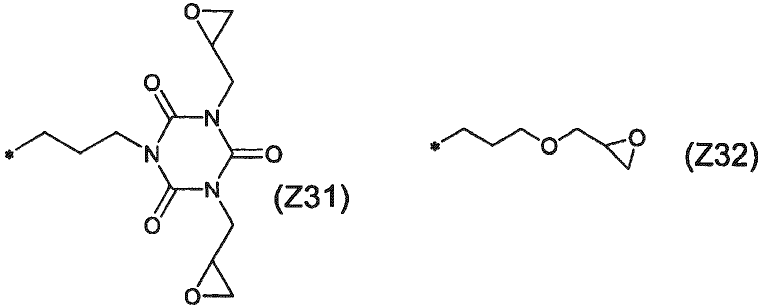 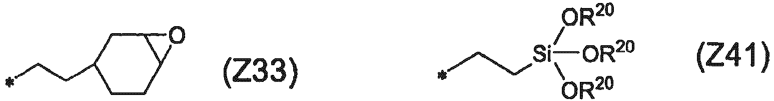
dans lesquelles, dans la formule (Z1), la formule (Z2), la formule (Z31), la formule (Z32), la formule (Z33) et la formule (Z41), * représente un site de liaison,
dans la formule (Z2), chaque R¹⁹ étant indépendamment un groupe phényle, cyclohexyle, cyclopentyle ou alkyle ayant 1 à 4 atomes de carbone et i étant une valeur moyenne satisfaisant étant comprise entre 1 à 20 et
dans la formule (Z41), chaque R²⁰ étant indépendamment un groupe méthyle, éthyle, butyle ou isopropyle.

9. Composition de résine thermodurcissable selon la revendication 8,
dans laquelle une teneur de l'agent impartissant une adhésion (D) est de 0,1 % en masse à 5 % en masse.

10. Composition de résine thermodurcissable selon l'une quelconque des revendications 1 à 9,
comprenant en outre :
un phosphore (E) ou un pigment blanc (F).

11. Corps moulé obtenu par durcissement de la composition de résine thermodurcissable selon l'une quelconque des revendications 1 à 10.

12. Dispositif de semiconducteur optique comprenant :
le corps moulé selon la revendication 11 ; et
un élément de semiconducteur optique scellé par ce corps moulé.

13. Composé organosilicium représenté par la formule (1-2), 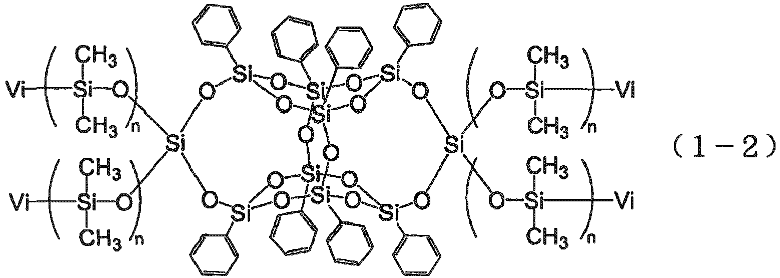 dans laquelle, dans la formule (1-2), chaque n est indépendamment une valeur moyenne moyennant quoi 1 < n ≤ 10 et Vi représente un groupe vinyle.
